# EUROPEAN PATENT APPLICATION

(11) **EP 4 300 472 A1**
(43) Date of publication of application: **03.01.2024**
(21) Application number: 23177558.6
(22) Date of filing: 06.06.2023
(51) Int. Cl.: G09G 3/32

(54) **PIXEL CIRCUIT COMPRISING PLURALITY OF LIGHT EMITTING ELEMENTS AND DISPLAY APPARATUS THEREOF**

(30) Priority: 30.06.2022 KR 20220080461
(71) Applicant: LG Display Co., Ltd., Seoul 07336 (KR)
(72) Inventor: KIM, Haksu, 10845 Paju-si (KR); BAEK, KwangHyun, 10845 Paju-si (KR); CHOI, SeongWook, 10845 Paju-si (KR); CHO, SeongHo, 10845 Paju-si (KR)
(74) Representative: Finlayson, Scott Henry

(57) **Abstract**

A display apparatus can comprise a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor, a second pixel circuit including a second driving transistor, a third transistor receiving the first light emission signal, a fourth transistor receiving the second light emission signal, a third light emitting element connected to the third transistor and a fourth light emitting element connected to the fourth transistor, at least three first lenses disposed on the first light emitting element, the second light emitting element and the third light emitting element, respectively, and at least one second lens disposed on the fourth light emitting element.

## Description

### CROSS-REFERENCE TO RELATED APPLICATION

This application claims the benefit of the Korean Patent Application No. 10-2022-0080461 filed on June 30, 2022 in the Republic of Korea.

### BACKGROUND

### Technical Field

The present disclosure relates to a pixel circuit comprising a plurality of light emitting elements and a display apparatus comprising the pixel circuit.

### Discussion of the Related Art

With the advancement of technologies in the modern society, a display apparatus has been used in various forms to provide users with information. The display apparatus is also included in various electronic devices, which check a user input and require higher technologies to provide information to correspond to the checked input, as well as an electronic display board that simply transfers visual information in one direction.

For example, the display apparatus can be included in a vehicle to provide various kinds of information to a driver and a passenger of the vehicle. However, the display apparatus of the vehicle needs to properly display contents so as not to disturb driving of the vehicle. For example, the display apparatus needs to limit a display of contents which can degrade concentration on driving during driving of the vehicle.

### SUMMARY

The present disclosure may provide a display circuit capable of adjusting a viewing angle of a display in accordance with a mode based on a plurality of light emitting elements and lenses disposed on the plurality of light emitting elements, and a display apparatus comprising the pixel circuit.

The present disclosure is not limited to the aforesaid, but other problems not described herein will be clearly understood by those skilled in the art from the following description of the present disclosure.

In accordance with an aspect of the present disclosure, a display apparatus can comprise a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor, a second pixel circuit including a second driving transistor, a third transistor receiving the first light emission signal, a fourth transistor receiving the second light emission signal, a third light emitting element connected to the third transistor and a fourth light emitting element connected to the fourth transistor, at least three first lenses disposed on the first light emitting element, the second light emitting element and the third light emitting element, respectively, and at least one second lens disposed on the fourth light emitting element.

Also disclosed herein is a display panel which comprises a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor, a second pixel circuit including a second driving transistor, a third transistor receiving the first light emission signal, a fourth transistor receiving the second light emission signal, a third light emitting element connected to the third transistor and a fourth light emitting element connected to the fourth transistor, at least three first lenses disposed on the first light emitting element, the second light emitting element and the third light emitting element, respectively, and at least one second lens disposed on the fourth light emitting element.

The details of another embodiments of the present disclosure will be included within this description and drawings of the present disclosure.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principles of the disclosure.

In the drawings:
FIG. 1 is a functional block view illustrating a display apparatus according to one embodiment of the present disclosure;
FIG. 2 is a view illustrating an example of a pixel circuit of a display apparatus according to one embodiment of the present disclosure;
FIG. 3 is a plan view illustrating a portion of a display apparatus according to the embodiment of the present disclosure;
FIG. 4 is a cross-sectional view taken along line I-I' of FIG. 3;
FIG. 5 is a cross-sectional view taken along line II-II' of FIG. 3;
FIG. 6 is an exemplary view illustrating that a display apparatus according to the embodiment of the present disclosure is disposed;
FIG. 7 is a detailed view illustrating a display apparatus according to the embodiment of the present disclosure;
FIGS. 8 and 9 are views illustrating an example of arrangement of a lens included in a display apparatus according to the embodiment of the present disclosure;
FIG. 10 is a view illustrating an example of arrangement of a lens and a pixel area, which are included in a display apparatus according to the embodiment of the present disclosure;
FIG. 11 is a view illustrating an example of a pixel circuit of a display apparatus according to the embodiment of the present disclosure;
FIG. 12 is a view illustrating an example of a signal flow of a display apparatus according to the embodiment of the present disclosure; and
FIGS. 13 to 15 are views illustrating an example of a screen displayed in accordance with a mode in a display apparatus according to the embodiment of the present disclosure.

### DETAILED DESCRIPTION OF THE EMBODIMENTS

The term used in embodiments has been selected from general terms currently widely used with consideration for functionality in this disclosure, but it can vary depending on the intent or promotion of those skilled in the art, the appearance of new technology, etc. If needed, the applicant can arbitrarily select the specific term. In this case, the meaning of the term will be described in detail in the corresponding description. Therefore, the term used in the present disclosure should be defined based on the meaning of the term and the contents throughout the disclosure, instead of the simple name of term.

When a certain part of the entire disclosure includes a certain element, this means not to exclude other components unless otherwise stated, but can further include other components.

The expression " at least one of A, B, and C " described throughout the disclosure can encompass "A alone", "B alone", "C alone", "A and B", "A and C", "B and C", or "all of A, B, and C". The advantages and features of the present disclosure, and methods of achieving them will become apparent with reference to the embodiments described in detail below in conjunction with the accompanying drawings.

The shapes, sizes, ratios, angles, and numbers disclosed in the drawings for describing embodiments of the present disclosure are merely examples, and thus the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted or can be briefly discussed.

In the case in which "comprise," "have", and "include" described in the present specification are used, another part can also be present unless "only" is used. The terms in a singular form can include plural forms unless noted to the contrary. In construing an element, the element is construed as including an error region although there is no explicit description thereof.

In describing a positional relationship, for example, when the positional order is described as "on," "above," "below," "beneath", and "next," etc., the case of no contact therebetween can be included, unless "direct" is used. For example, if it is mentioned that a first element is positioned "on" a second element, it does not mean that the first element is essentially or directly positioned above the second element in a figure.

It will be understood that, although the terms "first," "second," etc. can be used herein to describe various elements, these elements should not be limited by these terms. These terms are only used to distinguish one element from another and can not define any order or sequence. For example, a first element could be termed a second element, and, similarly, a second element could be termed a first element, without departing from the scope of the present disclosure.

The area, length, or thickness of each element described in the specification is illustrated for convenience of description, and the present disclosure is not necessarily limited to the area and thickness of the illustrated configuration.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

The terms to be described below are defined in consideration of the functions of the embodiments of the present specification and can be changed according to the intention of a user, an operator, or the like. Therefore, the definition should be made based on the contents throughout the specification.

A transistor included in a pixel circuit of the present disclosure can include at least one of an oxide thin film transistor Oxide TFT, an amorphous silicon a-Si TFT, and a low temperature polysilicon LTPS TFT.

The following embodiments are described with respect to an organic light emitting display apparatus. However, embodiments of the present disclosure are not limited to the organic light emitting display apparatus, and can be applied to other types of display apparatus, such as an inorganic light emitting display apparatus including an inorganic light emitting material. For example, embodiments of the present disclosure can be applied to a quantum dot display apparatus.

Terms such as "first", "second", and "third" are used to distinguish configurations for each embodiment, and the terms are not limited to these terms. Accordingly, even though the same terms are used, it can refer to other configurations according to the embodiments.

Hereinafter, embodiments of the present disclosure will be described with reference to the drawings. All components of each display apparatus according to all embodiments of the present disclosure are operatively coupled and configured.

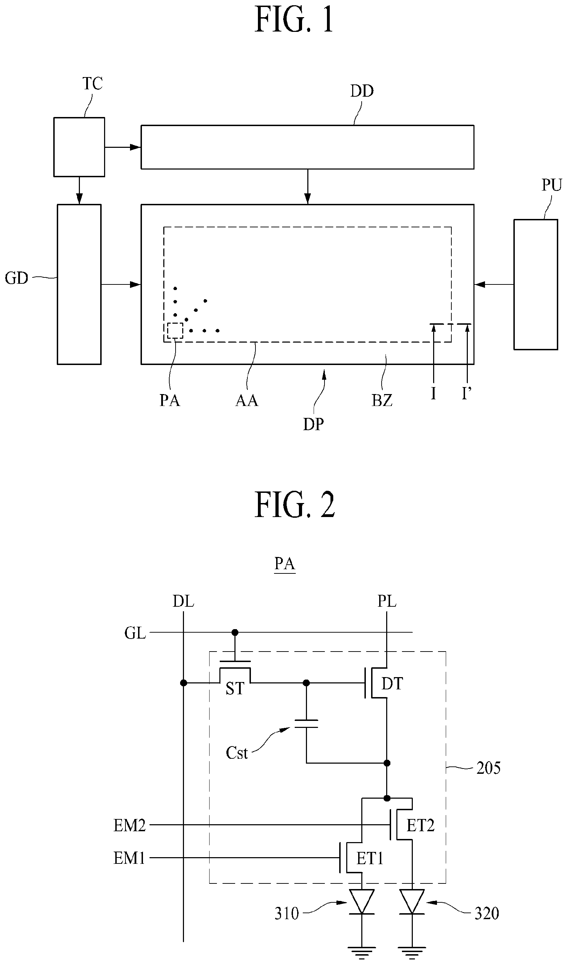

FIG. 1 is a functional block view illustrating a display apparatus according to one embodiment of the present disclosure.

The display apparatus according to one embodiment of the present disclosure can be applied with an electroluminescent display apparatus. The electroluminescent display apparatus can be an Organic Light Emitting Diode display apparatus, a Quantum-dot Light Emitting Diode display apparatus or an Inorganic Light Emitting Diode display apparatus.

Referring to FIG. 1, the display apparatus can include a display panel DP, a data driver DD, a gate driver GD, a timing controller TC and a power unit PU

In the embodiment, the display panel DP can generate an image to be provided to a user. For example, the display panel DP can generate and display an image to be provided to the user through a pixel area PA in which a pixel circuit is disposed.

The data driver DD, the gate driver GD, the timing controller TC and the power unit PU can provide a signal for the operation of each pixel area PA through signal lines. The signal lines can include, for example, data lines DL, gate lines GL and power voltage supply lines PL, which are shown in FIG. 2.

For example, the data driver DD can apply a data signal to each pixel area PA through the data lines DL, the gate driver GD can apply a gate signal to each pixel area PA through the gate lines GL, and the power unit PU can supply a power voltage to each pixel area PA through the power voltage supply lines PL.

The timing controller TC can control the data driver DD and the gate driver GD. For example, the timing controller TC realigns digital video data input from the outside in accordance with resolution of the display panel DP and supplies the realigned digital video data to the data driver DD.

The data driver DD can convert the digital video data input from the timing controller TC into an analog data voltage based on a data control signal and supply the analog data voltage to the plurality of data lines.

The gate driver GD can generate a scan signal and a light emission signal (or light emission control signal) based on a gate control signal. The gate driver GD can include a scan driver and a light emission signal driver. The scan driver can generate scan signals in a row sequential manner to drive at least one scan line connected to each pixel row and supply the scan signals to the scan lines. The light emission signal driver can generate light emission signals in a row sequential manner to drive at least one light emission signal line connected to each pixel row and supply the light emission signals to the light emission signal lines.

According to the embodiment, the gate driver GD can be disposed on the display panel DP in accordance with a Gate-driver In Panel (GIP) method. For example, the gate driver GD can be divided into a plurality of gate drivers GD and then disposed on at least two sides of the display panel DP, respectively. For another example, the gate driver GD can be disposed in the display area AA.

The display area AA of the display panel DP can include a plurality of pixel areas PA (or pixels or pixel circuits). A plurality of data lines (e.g., the data lines DL of FIG. 2) and a plurality of gate lines (e.g., the gate lines GL of FIG. 2) cross with each other in the pixel area PA, and subpixels disposed in each crossing area can be included in the pixel area PA. The respective subpixels included in one pixel area PA can emit light of their respective colors different from each other. For example, the pixel area PA can implement blue, red and green colors by using three subpixels, but is not limited thereto. The pixel area PA can further include a subpixel for further implementing a specific color (e.g., white or yellow) as the case can be.

In the pixel area PA, an area implementing blue can be referred to as a blue subpixel area, an area implementing red can be referred to as a red subpixel area, and an area implementing green can be referred to as a green subpixel area.

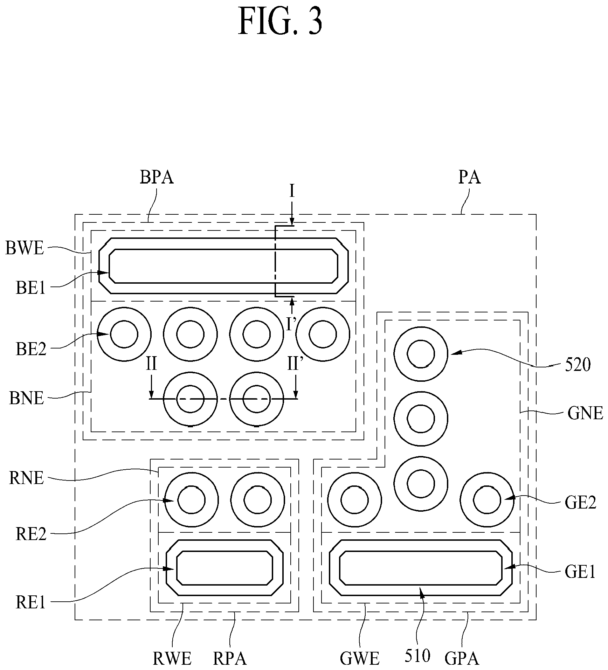

In the embodiment, the pixel area PA can include a plurality of subpixels. Each of the plurality of subpixels can be divided into a first lens area and a second lens area, which provide their respective viewing angles different from each other. For example, the pixel area PA can include a first lens area that provides light to a first range to form a first viewing angle and a second lens area that provides light to a second range to form a second viewing angle. The first range can correspond to a range wider than the second range. This will be described in more detail with reference to FIG. 3.

A non-display area BZ can be disposed along the periphery of the display area AA. Various elements for driving the pixel circuit disposed in the pixel area PA can be disposed in the non-display area BZ. For example, at least a portion of the gate driver GD can be disposed in the non-display area BZ. The non-display area BZ can be referred to as a bezel area.

FIG. 2 illustrates an example of a pixel circuit of a display apparatus according to one embodiment of the present disclosure. The pixel area PA can include a plurality of subpixels representing different colors and a pixel circuit corresponding to each of the plurality of subpixels. FIG. 2 illustrates an example of a pixel circuit corresponding to one subpixel disposed in the pixel area PA.

Referring to FIG. 2, the pixel circuit can include a plurality of transistors DT, ST, ET1 and ET2, a capacitor Cst and a plurality of light emitting elements 310 and 320.

The driving transistor DT and the capacitor Cst can be connected to the switching transistor ST. A first electrode of the driving transistor DT can be connected to the power voltage supply line PL.

The switching transistor ST is connected to the gate line GL to receive the gate signal. The switching transistor ST can be turned on or off by the gate signal. A first electrode of the switching transistor ST can be connected to the data line DL. In this case, the data signal can be supplied to a gate electrode of the driving transistor DT through the switching transistor ST in response to turn-on of the switching transistor ST.

The capacitor Cst can be disposed between the gate electrode and a second electrode of the driving transistor DT. The capacitor Cst can maintain a signal, for example, a data signal, applied to the gate electrode of the driving transistor DT during one or more frames.

According to the embodiment, the driving transistor DT, the switching transistor ST and the capacitor Cst can be elements for driving the light emitting element (e.g., the first light emitting element 310 and the second light emitting element 320), and can be referred to as driving portions 205, but are not limited to such terms.

The first light emitting element 310 can be connected to the first transistor ET1 turned on or off by a first light emission signal EM1. The second light emitting element 320 can be connected to the second transistor ET2 turned on or off by a second light emission signal EM2. The driving portion 205 of the pixel circuit further includes the first and second transistors ET1 and ET2.

In this case, the first light emitting element 310 or the second light emitting element 320 can be connected to another element of the pixel circuit, for example, the driving transistor DT in accordance with a mode. The mode can be designated by a user input, or can be determined when a predesignated condition is satisfied. For example, when a predesignated first condition is satisfied, the first light emitting element 310 can emit light based on the supply of the first light emission signal EM1. When a predesignated second condition is satisfied, the second light emitting element 320 can emit light based on the supply of the second light emission signal EM2. The first condition can include a predesignated condition for driving a first mode. The second condition can include a predesignated condition for driving a second mode.

The plurality of transistors of FIG. 2 can include at least one of amorphous silicon, polycrystalline silicon or oxide semiconductor such as IGZO. The first electrode or the second electrode of the transistor can be a source electrode or a drain electrode. For example, the first electrode can be a source electrode, and the second electrode can be a drain electrode. For another example, the first electrode can be a drain electrode, and the second electrode can be a source electrode.

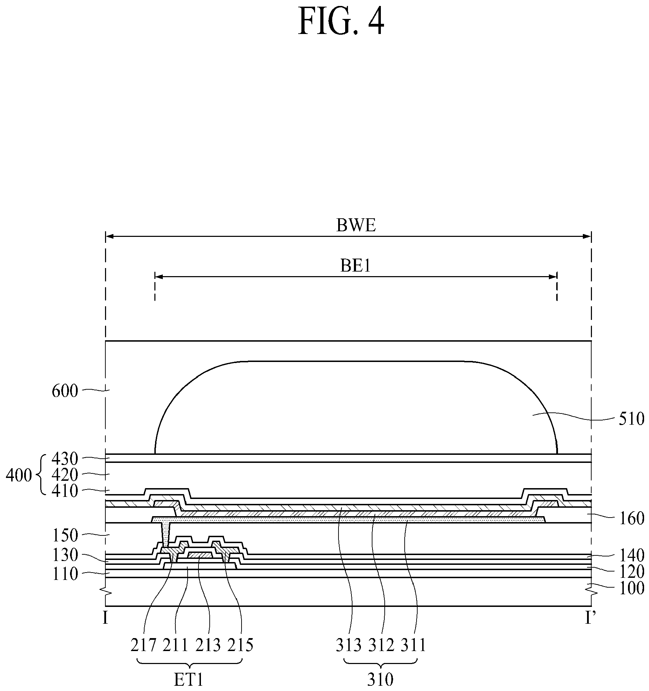

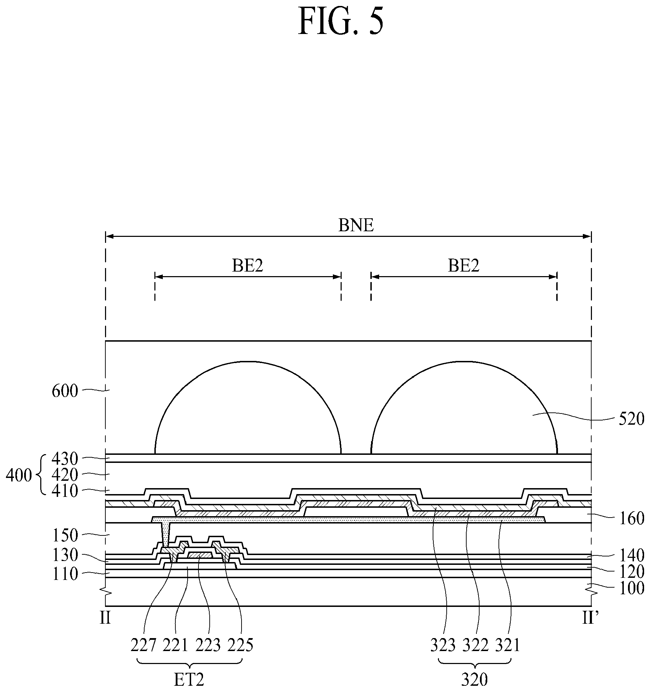

FIG. 3 illustrates a plane of a portion of a display apparatus according to one embodiment of the present disclosure. FIG. 3 illustrates a plane of a pixel area PA when three subpixels are disposed in the pixel area PA. FIG. 4 is a cross-sectional view taken along line I-I' of FIG. 3, and FIG. 5 is a cross-sectional view taken along line II-II' of FIG. 3. Hereinafter, the description will be given with reference to FIGS. 3 to 5.

In FIG. 3, the pixel area PA can include a blue subpixel area BPA for implementing blue, a red subpixel area RPA for implementing red, and a green subpixel area GPA for implementing green. According to the embodiment, the blue subpixel area BPA can correspond to a first subpixel, the red subpixel area RPA can correspond to a second subpixel, and the green subpixel area GPA can correspond to a third subpixel. The pixel circuit can correspond to each of the subpixels. A corresponding pixel circuit can be disposed for each of the subpixels.

The pixel area PA can include first lens areas BWE, RWE and GWE and second lens areas BNE, RNE and GNE, which provide different viewing angles. The second lens areas BNE, RNE and GNE of each pixel area PA can operate independently of the first lens areas BWE, RWE and GWE of the corresponding pixel area PA. For example, each pixel area PA can include a first light emitting element 310 (e.g., the first light emitting element 310 of FIG. 2) positioned on the first lens areas BWE, REW and GWE of the corresponding pixel area PA and a second light emitting element 320 (e.g., the second light emitting element 320 of FIG. 2) positioned on the second lens areas BNE, RNE and GNE of the corresponding pixel area PA.

In the embodiment, at least one first lens 510 can be disposed in each of the first lens areas BWE, RWE and GWE. At least one second lens 520 can be disposed in each of the second lens areas BNE, RNE and GNE. For example, one first lens 510 can be disposed in each of the first lens areas BWE, RWE and GWE, and two second lenses 520 can be disposed in each of the second lens areas BNE, RNE and GNE.

In the embodiment, sizes of at least some of the first lenses 510 respectively included in the first lens areas BWE, RWE and GWE can be different from each other. For example, the size of the first lens 510 included in the first lens area BWE corresponding to blue can be different from the size of the first lens 510 included in the first lens area RWE corresponding to red.

In the embodiment, the numbers of second lenses 520 respectively included in at least two areas among the second lens area BNE corresponding to blue, the second lens area RNE corresponding to red and the second lens area GNE corresponding to green can be different from each other. For example, the number of second lenses 520 included in the second lens area BNE corresponding to blue and the number of second lenses 520 included in the second lens area RNE corresponding to red can be different from each other. For another example, the number of second lenses 520 included in the second lens area GNE corresponding to green and the number of second lenses 520 included in the second lens area RNE corresponding to red can be different from each other.

The first light emitting element 310 can emit light representing a specific color. For example, the first light emitting element 310 can include a first lower electrode 311, a first light emitting layer 312 and a first upper electrode 313, which are sequentially stacked on a substrate 100. The substrate 100 can include an insulating material. The substrate 100 can include a transparent material. For example, the substrate 100 can include glass or plastic.

The first lower electrode 311 can include a conductive material. The first lower electrode 311 can include a material having high reflectance. For example, the first lower electrode 311 can include a metal such as aluminum (Al) and silver (Ag). The first lower electrode 311 can have a multi-layered structure. For example, the first lower electrode 311 can have a structure in which a reflective electrode made of metal is positioned between transparent electrodes made of a transparent conductive material such as ITO and IZO.

The first light emitting layer 312 can generate light of luminance corresponding to a voltage difference between the first lower electrode 311 and the first upper electrode 313. For example, the first light emitting layer 312 can include an Emission Material Layer (EML) that includes a light emitting material. The light emitting material can include an organic material, an inorganic material or a hybrid material.

The first light emitting layer 312 can have a multi-layered structure. For example, the first light emitting layer 312 can further include at least one of a Hole Injection Layer (HIL), a Hole Transport Layer (HTL), an Electron Transport Layer (ETL) or an Electron Injection Layer (EIL).

The first upper electrode 313 can include a conductive material. The first upper electrode 313 can include a material different from that of the first lower electrode 311. Transmittance of the first upper electrode 313 can be higher than that of the first lower electrode 311. For example, the first upper electrode 313 can be a transparent electrode made of a transparent conductive material such as ITO and IZO. Therefore, in the display apparatus according to the embodiment of the present disclosure, light generated by the first light emitting layer 312 can be emitted through the first upper electrode 313.

The second light emitting element 320 can implement the same color as that of the first light emitting element 310. The second light emitting element 320 can have the same structure as that of the first light emitting element 310. For example, the second light emitting element 320 can include a second lower electrode 321, a second light emitting layer 322 and a second upper electrode 323, which are sequentially stacked on the substrate 100.

The second lower electrode 321 can correspond to the first lower electrode 311, the second light emitting layer 322 can correspond to the first light emitting layer 312, and the second upper electrode 323 can correspond to the first upper electrode 313. For example, the second lower electrode 321 can be formed with respect to the second light emitting element 320 in the same structure as that of the first lower electrode 311, and this can be equally applied to the second light emitting layer 322 and the second upper electrode 323. That is, the first light emitting element 310 and the second light emitting element 320 can be formed to have the same structure, but the present disclosure is not limited thereto. In some cases, at least some elements of the first light emitting element 310 and the second light emitting element 320 can be formed differently.

In the embodiment, the second light emitting layer 322 can be spaced apart from the first light emitting layer 312. Therefore, in the display apparatus according to the embodiment of the present disclosure, light emission due to leakage current can be avoided. Also, in the display apparatus according to the embodiment of the present disclosure, light can be generated only in one of the first light emitting layer 312 and the second light emitting layer 322 in accordance with a user's selection or a predesignated condition.

In the embodiment, the first light emitting element 310 and the second light emitting element 320 of the pixel area PA can be positioned on a driving portion (e.g., the driving portion 205 of FIG. 2) of the corresponding pixel area PA. For example, at least one insulating film (e.g., a element buffer film 110, a gate insulating film 120, an interlayer insulating film 130, a lower passivation film 140 and an overcoat layer 150) can be positioned on the substrate 100, and the first light emitting element 310 and the second light emitting element 320 of each pixel area PA can be disposed on one of the insulating films. Therefore, in the display apparatus according to the embodiment of the present disclosure, the first light emitting element 310 and the second light emitting element 320 of each pixel area PA can be prevented from being unnecessarily connected to the driving portion 205 of the corresponding pixel area PA.

In the embodiment, the element buffer film 110, the gate insulating film 120, the interlayer insulating film 130, the lower passivation film 140 and the overcoat layer 150 can be stacked on the substrate 100. The element buffer film 110 can include an insulating material. For example, the element buffer film 110 can include an inorganic insulating material such as silicon oxide (SiO) or silicon nitride (SiN). The element buffer film 110 can have a multi-layered structure. For example, the element buffer film 110 can have a stacked structure of a film made of silicon nitride (SiN) and a film made of silicon oxide (SiO).

In the embodiment, the element buffer film 110 can be positioned between the element substrate 100 and the driving portion 205 of each pixel area PA. The element buffer film 110 can prevent contamination caused by the substrate 100 in a process of forming the driving portion 205. For example, an upper surface of the substrate 100 directed toward the driving portion 205 of each pixel area PA can be covered by the element buffer film 110. The driving portion 205 of each pixel area PA can be positioned on the element buffer film 110.

In the embodiment, the gate insulating film 120 can include an insulating material. For example, the gate insulating film 120 can include an inorganic insulating material such as silicon oxide (SiO) and silicon nitride (SiN). The gate insulating film 120 can include a material having a high dielectric constant. For example, the gate insulating film 120 can include a High-K material such as hafnium oxide (HfO). The gate insulating film 120 can have a multi-layered structure.

The gate insulating film 120 can be positioned on the element buffer film 110. The gate insulating film 120 can be extended between a gate electrode and a semiconductor pattern of a transistor. For example, the gate electrode of the driving transistor DT and the switching transistor ST can be insulated from the semiconductor pattern of the driving transistor DT and the switching transistor ST by the gate insulating film 120. The gate insulating film 120 can cover a first semiconductor pattern and a second semiconductor pattern of each pixel area PA. The gate electrode of the driving transistor DT and the switching transistor ST can be positioned on the gate insulating film 120.

The interlayer insulating film 130 can include an insulating material. For example, the interlayer insulating film 130 can include an inorganic insulating material such as silicon oxide (SiO) or silicon nitride (SiN). The interlayer insulating film 130 can be positioned on the gate insulating film 120. The interlayer insulating film 130 can be extended between the gate electrode and the source electrode of each of the driving transistor DT and the switching transistor ST and between the gate electrode and the drain electrode thereof. For example, the source electrode and the drain electrode of each of the driving transistor DT and the switching transistor ST can be insulated from the gate electrode thereof by the interlayer insulating film 130. The interlayer insulating film 130 can cover the gate electrode of each of the driving transistor DT and the switching transistor ST. A source electrode and a drain electrode of each pixel area PA can be disposed on the interlayer insulating film 130. The gate insulating film 120 and the interlayer insulating film 130 can expose a source area and a drain area of each semiconductor pattern positioned in each pixel area PA.

In the embodiment, the lower passivation film 140 can include an insulating material. For example, the lower passivation layer 140 can include an inorganic insulating material such as silicon oxide (SiO) and silicon nitride (SiN). The lower passivation film 140 can be positioned on the interlayer insulating film 130. The lower passivation layer 140 can prevent the driving portion 205 from being damaged due to external moisture and impact. The lower passivation film 140 can be extended along surfaces of the switching transistor ST and the driving transistor DT, which are opposite to the substrate 100. The lower passivation film 140 can be in contact with the interlayer insulating film 130 outside the driving portion 205 positioned in each pixel area PA.

The overcoat layer 150 can include an insulating material. The overcoat layer 150 can include a material different from that of the lower passivation film 140. For example, the overcoat layer 150 can include an organic insulating material. The overcoat layer 150 can be positioned on the lower passivation film 140. The overcoat layer 150 can remove a step difference caused by the driving portion 205 of each pixel area PA. For example, an upper surface of the overcoat layer 150 facing the element substrate 100 can be a flat surface.

In the embodiment, the first transistor ET1 can be electrically connected between the drain electrode of the driving transistor DT and the first lower electrode 311 of the first light emitting element 310. The second transistor ET2 can be electrically connected between the drain electrode of the driving transistor DT and the second lower electrode 321 of the second light emitting element 320.

The first transistor ET1 can include a first light emitting semiconductor pattern 211, a first light emitting gate electrode 213, a first light emitting source electrode 215 and a first light emitting drain electrode 217. The first transistor ET1 can have the same structure as that of switching transistor ST and the driving transistor DT. For example, the first light emitting semiconductor pattern 211 can be positioned between the element buffer film 110 and the gate insulating film 120, and the first light emitting gate electrode 213 can be positioned between the gate insulating film 120 and the interlayer insulating film 130. The first light emitting source electrode 215 and the first light emitting drain electrode 217 can be positioned between the interlayer insulating film 130 and the lower passivation film 140. The first light emitting gate electrode 213 can overlap a channel area of the first light emitting semiconductor pattern 211. The first light emitting source electrode 215 can be electrically connected to a source area of the first light emitting semiconductor pattern 211. The first light emitting drain electrode 217 can be electrically connected to a drain area of the first light emitting semiconductor pattern 211.

In the embodiment, the second transistor ET2 includes a second light emitting semiconductor pattern 221, a second light emitting gate electrode 223, a second light emitting source electrode 225 and a second light emitting drain electrode 227. For example, the second light emitting semiconductor pattern 221 can be positioned on the same layer as the first light emitting semiconductor pattern 211, the second light emitting gate electrode 223 can be positioned on the same layer as the first light emitting gate electrode 213, and the second light emitting source electrode 225 and the second light emitting drain electrode 227 can be positioned on the same layer as the first light emitting source electrode 215 and the first light emitting drain electrode 217.

In the embodiment, the first transistor ET1 can be formed simultaneously with the switching transistor ST and the driving transistor DT. The first transistor ET1 can be formed simultaneously with the second transistor ET2.

The first light emitting element 310 and the second light emitting element 320 of each pixel area PA can be positioned on the overcoat layer 150 of the corresponding pixel area PA. For example, the first lower electrode 311 of the first light emitting element 310 can be electrically connected to the first light emitting drain electrode 217 of the first transistor ET1 by passing through the lower passivation film 140 and the overcoat layer 150, and the second lower electrode 321 of the second light emitting element 320 can be electrically connected to the second light emitting drain electrode 227 of the second transistor ET2 by passing through the lower passivation film 140 and the overcoat layer 150.

The second lower electrode 321 of each pixel area PA can be spaced apart from the first lower electrode 311 of the corresponding pixel area PA. For example, a bank insulating film 160 can be positioned between the first lower electrode 311 and the second lower electrode 321 of each pixel area PA. The bank insulating film 160 can include an insulating material. For example, the bank insulating film 160 can include an organic insulating material. The bank insulating film 160 can include a material different from that of the overcoat layer 150.

The second lower electrode 321 of each pixel area PA can be insulated from the first lower electrode 311 of the corresponding pixel area PA by the bank insulating film 160. For example, the bank insulating film 160 can cover the edge of the first lower electrode 311 and the edge of the second lower electrode 321, which are positioned in each pixel area PA. Therefore, in the display apparatus, an image by the first lens areas BWE, RWE and GWE of each pixel area PA in which the first light emitting element 310 is positioned or an image by the second lens areas BNE, RNE and GNE of each pixel area PA in which the second light emitting element 320 is positioned can be provided to the user.

The first light emitting layer 312 and the first upper electrode 313 of the first light emitting element 310 positioned in each pixel area PA can be stacked on a partial area of the corresponding first lower electrode 311 exposed by the bank insulating film 160. The second light emitting layer 322 and the second upper electrode 323 of the second light emitting element 320 positioned in each pixel area PA can be stacked on a partial area of the corresponding second lower electrode 321 exposed by the bank insulating film 160. For example, the bank insulating film 160 can distinguish the first light emitting areas BE1, RE1 and GE1 from which light by the first light emitting element 310 is emitted in each pixel area PA from the second light emitting areas BE2, RE2 and GE2 from which light by the second light emitting element 320 is emitted. The size of the second light emitting areas BE2, RE2 and GE2 distinguished in each pixel area PA can be smaller than that of the first light emitting areas BE1, RE1 and GE1.

The second upper electrode 323 of each pixel area PA can be electrically connected to the first upper electrode 313 of the corresponding pixel area PA. For example, a voltage applied to the second upper electrode 323 of the second light emitting element 320 positioned in each pixel area PA can be the same as that applied to the first upper electrode 313 of the first light emitting element 310 positioned in the corresponding pixel area PA. The second upper electrode 323 of each pixel area PA can include the same material as that of the first upper electrode 313 of the corresponding pixel area PA. For example, the second upper electrode 323 of each pixel area PA can be formed simultaneously with the first upper electrode 313 of the corresponding pixel area PA. The second upper electrode 323 of each pixel area PA can be extended onto the bank insulating film 160 to directly contact the first upper electrode 313 of the corresponding pixel area PA. Luminance of the first lens areas BWE, RWE and GWE positioned in each pixel area PA and luminance of the second lens areas BNE, RNE and GNE can be controlled by a driving current generated in the corresponding pixel area PA.

An encapsulation member 400 can be positioned on the first light emitting element 310 and the second light emitting element 320 of each pixel area PA. The encapsulation member 400 can prevent the light emitting elements 310 and 320 from being damaged due to external moisture and impact. The encapsulation member 400 can have a multi-layered structure. For example, the encapsulation member 400 can include a first encapsulation layer 410, a second encapsulation layer 420 and a third encapsulation layer 430, which are sequentially stacked. The first encapsulation layer 410, the second encapsulation layer 420 and the third encapsulation layer 430 can include an insulating material. The second encapsulation layer 420 can include a material different from that of the first encapsulation layer 410 and the third encapsulation layer 430. For example, the first encapsulation layer 410 and the third encapsulation layer 430 can be inorganic encapsulation layers that includes an inorganic insulation material, and the second encapsulation layer 420 can include an organic encapsulation layer that includes an organic insulation material. Therefore, the light emitting elements 310 and 320 of the display apparatus can be more effectively prevented from being damaged by external moisture and impact.

The first lens 510 and the second lens 520 can be positioned on the encapsulation member 400 of each pixel area PA.

The first lens 510 can be positioned on the first lens areas BWE, RWE and GWE of each pixel area PA. For example, light generated by the first light emitting element 310 of each pixel area PA can be emitted through the first lens 510 of the corresponding pixel area PA. The first lens 510 can have a shape in which light in at least one direction can not be limited. For example, a planar shape of the first lens 510 positioned in each pixel area PA can have a bar shape extended in the first direction.

In this case, a moving direction of light emitted from the first lens areas BWE, RWE and GWE of the pixel area PA can not be limited to the first direction. For example, a content (or image) provided through the first lens areas BWE, RWE and GWE of the pixel area PA can be shared with surrounding people adjacent to the user in the first direction. The case that the content is provided through the first lens areas BWE, RWE and GWE is a mode for providing the content in a first viewing angle range wider than a second viewing angle range provided by the second lens areas BNE, RNE and GNE, and can be referred to as a first mode.

The second lens 520 can be positioned on the second lens areas BNE, RNE and GNE of each pixel area PA. Light generated by the second light emitting element 320 of the pixel area PA can be emitted through the second lens 520 of the corresponding pixel area PA. The second lens 520 can limit a moving direction of light, which passes therethrough, to the first direction and/or the second direction. For example, a planar shape of the second lens 520 positioned in the pixel area PA can have a circular shape. In this case, the moving direction of light emitted from the second lens areas BNE, RNE and GNE of the pixel area PA can be limited to the first direction and the second direction. That is, the content provided by the second lens areas BNE, RNE and GNE of the pixel area PA can not be shared with people around the user. The case that the content is provided through the second lens areas BNE, RNE and GNE is a mode for providing the content in a second viewing angle range narrower than a first viewing angle range provided by the first lens areas BWE, RWE and GWE, and can be referred to as a second mode.

The first light emitting areas BE1, RE1 and GE1 included in the first lens areas BWE, RWE and GWE of each pixel area PA can have a shape corresponding to the first lens 510 positioned on the first lens areas BWE, RWE and GWE of the corresponding pixel area PA. For example, a planar shape of the first light emitting areas BE1, RE1 and GE1 defined in the first lens areas BWE, RWE and GWE of each pixel area PA can have a bar shape extended in the first direction. The first lens 510 positioned on the first lens areas BWE, RWE and GWE of the pixel area PA can have a size greater than that of the first light emitting areas BE1, RE1 and GE1 included in the first lens areas BWE, RWE and GWE of the corresponding pixel area PA. Therefore, efficiency of light emitted from the first light emitting areas BE1, RE1 and GE1 of the pixel area PA can be improved.

The second light emitting areas BE2, RE2 and GE2 included in the second lens areas BNE, RNE and GNE of each pixel area PA can have a shape corresponding to the second lens 520 positioned on the second lens areas BNE, RNE and GNE of the corresponding pixel area PA. For example, a planar shapes of the second light emitting areas BE2, RE2 and GE2 included in the second lens areas BNE, RNE and GNE of the pixel area PA can have a circular shape. The second lens 520 positioned on the second lens areas BNE, RNE and GNE of the pixel area PA can have a size greater than that of the second light emitting areas BE2, RE2 and GE2 included in the second lens areas BNE, RNE and GNE of the corresponding pixel area PA. For example, the planar shape of the second light emitting areas BE2, RE2 and GE2 positioned in the second lens areas BNE, RNE and GNE of each pixel area PA can be concentric with the planar shape of the second lens 520 positioned on the second lens areas BNE, RNE and GNE of the corresponding pixel area PA. In this case, efficiency of light emitted from the second light emitting areas BE2, RE2 and GE2 of the pixel area PA can be improved.

In the embodiment, the first lens area BWE, RWE or GWE of the pixel area PA can include one first light emitting area BE1, RE1 or GE1. The second lens areas BNE, RNE and GNE of the pixel area PA can include a plurality of second light emitting areas BE2, RE2 and GE2.

In the embodiment, one first lens 510 can be disposed on the first lens areas BWE, RWE and GWE of the pixel area PA. The plurality of second lenses 520 can be disposed on the second lens areas BNE, RNE and GNE of the pixel area PA.

In one embodiment, the second light emitting areas BE2, RE2 and GE2 included in the second lens areas BNE, RNE and GNE of the pixel area PA can be driven for each subpixel area. The second light emitting areas (e.g., second light emitting areas BE2, second light emitting areas RE2 or second light emitting areas GE2) included in one subpixel area can be simultaneously driven.

In the embodiment, one second lower electrode 321 can be positioned on the second lens areas BNE, RNE and GNE of each pixel area PA. The bank insulating film 160 can be positioned between the second lower electrode 321 and the second light emitting layer 322 between the second light emitting areas BE2, RE2 and GE2. Between the second light emitting areas BE2, between the second light emitting areas RE2 and/or between the second light emitting areas GE2, the bank insulating film 160 can be positioned between the second lower electrode 321 and the second light emitting layer 322. The second light emitting layer 322 can be spaced apart from the second lower electrode 321 by the bank insulating film 160 between the second light emitting areas BE2, RE2 and GE2 of the respective second lens areas BNE, RNE and GNE. In this case, light emitting efficiency of the second light emitting areas BE2, RE2 and GE2 can be improved.

In the embodiment, an area of each of the second light emitting areas BE2, RE2 and GE2 positioned in the second lens areas BNE, RNE and GNE of the pixel area PA can be designated by a specific value. For example, the second light emitting areas BE2, RE2 and GE2 positioned in the second lens areas BNE, RNE and GNE can be implemented to have the same area. Each of the second light emitting areas BE2, RE2 and GE2 positioned in the second lens areas BNE, RNE and GNE of the pixel area PA can have the same area as that of each of the second light emitting areas BE2, RE2 and GE2 included in the second lens areas BNE, RNE and GNE of another adjacent pixel area PA.

In the embodiment, the number of second light emitting areas can be different for each of the subpixel areas RPA, GPA and BPA. For example, the number of second light emitting areas BE2 defined in the second lens area BNE of the blue subpixel area BPA can be greater than the number of second light emitting areas RE2 defined in the second lens area RNE of the red subpixel area RPA. The number of second light emitting areas RE2 defined in the second lens area RNE of the red subpixel area RPA can be greater than the number of second light emitting areas GE2 defined in the second lens area GNE of the green subpixel area GPA. In this case, an efficiency deviation of the second light emitting element 320 positioned on the second lens areas BNE, RNE and GNE of the pixel area PA can be supplemented by the number of second light emitting areas BE2, RE2 and GE2 defined in the second lens areas BNE, RNE and GNE of each pixel area PA.

In the embodiment, the sizes of first light emitting areas BE1, RE1 and GE1 can be different for each of the subpixel areas RPA, GPA and BPA. For example, the first light emitting area BE1 of the blue subpixel area BPA can have a size different from that of the first light emitting area RE1 of the red subpixel area RPA, and can have a size different from that of the first light emitting area GE1 of the green subpixel area GPA. The size of the first light emitting area BE1 of the blue subpixel area BPA can be greater than that of the first light emitting area RE1 of the red subpixel area RPA. The size of the first light emitting area RE1 of the red subpixel area RPA can be greater than that of the first light emitting area GE1 of the green subpixel area GPA. Therefore, in the display apparatus according to the embodiment of the present disclosure, a efficiency deviation of the first light emitting element 310 positioned on the first lens areas BWE, RWW and GWE of each pixel area PA can be supplemented by the sizes of the first light emitting areas BE1, RE1 and GE1 defined in the first lens areas BWE, RWE and GWE of each pixel area PA.

In the embodiment, a lens passivation film 600 can be positioned on the first lens 510 and the second lens 520 of the pixel area PA. The lens passivation film 600 can include an insulating material. For example, the lens passivation film 600 can include an organic insulation material. A refractive index of the lens passivation film 600 can be smaller than a refractive index of each of the first lens 510 and the second lens 520, which are positioned in each pixel area PA. Therefore, in the display apparatus according to the embodiment of the present disclosure, light passing through the first lens 510 and the second lens 520 of each pixel area PA can not be reflected in the direction of the substrate 100 due to a difference in the refractive index from the lens passivation film 600.

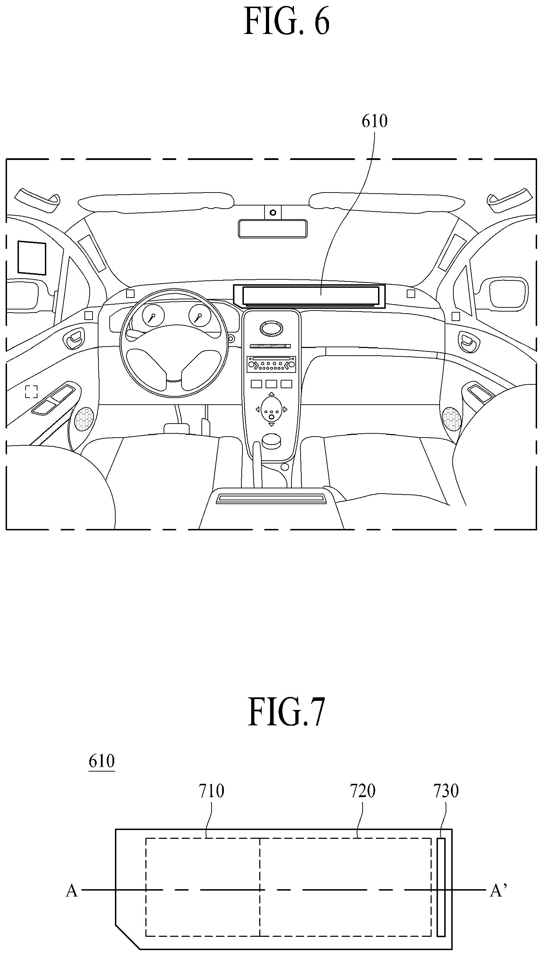

FIG. 6 is an exemplary view illustrating that a display apparatus according to one embodiment of the present disclosure is disposed. FIG. 6 is a detailed view illustrating that a display apparatus is disposed in a vehicle.

Referring to FIG. 6, a display apparatus 610 can be disposed on at least a portion of a dash board of a vehicle. The dash board of the vehicle includes components disposed on a front surface of a front seat (e.g., a driver's seat and a passenger seat) of the vehicle. For example, input components for manipulating various functions (e.g., an air conditioner, an audio system and a navigation system) inside the vehicle can be disposed on the dash board of the vehicle.

In the embodiment, the display apparatus 610 can be disposed on the dash board of the vehicle, and can operate as an input for manipulating at least a portion of the various functions of the vehicle. The display apparatus 610 can provide various kinds of information related to the vehicle, for example, driving information (e.g., a current speed of the vehicle, a remaining fuel amount and a driving distance) of the vehicle, and information (e.g., damage to a vehicle tire) of components of the vehicle.

The display apparatus 610 can be disposed across a driver's seat and a passenger seat, which are disposed in the front seat of the vehicle, as shown. A user of the display apparatus 610 can include a driver of the vehicle and a passenger on the passenger seat of the vehicle. That is, both the driver and the passenger of the vehicle can use the display apparatus 610.

In the embodiment, the display apparatus 610 can be divided into a plurality of areas. For example, the display apparatus 610 can be divided into a first area disposed to be adjacent to the driver and a second area disposed to be adjacent to the passenger seat. The first area and the second area can be formed by dividing an area in which a content is displayed in a display area of the display apparatus 610. In this case, the driver's seat of the vehicle can correspond to a seat on which a handle for driving the vehicle is disposed, that is, a seat on which a person driving the vehicle sits. The passenger seat is a seat other than the driver's seat, and can correspond to a seat on which a passenger in the vehicle sits.

In the embodiment, the first area and the second area can be implemented as different display apparatuses, respectively, but the present disclosure is not limited thereto, and can correspond to areas divided on one display apparatus 610 as shown.

In the embodiment, the display apparatus 610 shown in FIG. 6 can correspond to at least a portion of a display panel (e.g., the display panel DP of FIG. 1) included in the display apparatus 610. For example, the display apparatus 610 shown in FIG. 6 can represent at least a portion of a display area or a non-display area of the display panel. The components other than portions illustrated in FIG. 6 of the components of the display apparatus 610 can be packaged inside the vehicle.

FIG. 7 is a detailed view illustrating a display apparatus according to the embodiment of the present disclosure.

Referring to FIG. 7, a display area AA of the display apparatus 610 can be divided into a first area 710 and a second area 720. The first area 710 can include a partial area of the display apparatus 610 adjacent to the driver's seat of the vehicle. The second area 720 can include a partial area of the display apparatus 610 adjacent to the passenger seat of the vehicle.

In the embodiment, the first area 710 can operate in the first mode, and the second area 720 can operate in the first mode or the second mode. For example, the first area 710 can operate in the first mode having a viewing angle wider than that of the second area. The second area 720 can operate in the first mode or the second mode having a viewing angle narrower than that of the first area 710. For another example, the first area 710 can operate in the first mode for providing a content to both users positioned in the driver's seat and the passenger seat of the vehicle. The second area 720 can operate in the first mode or the second mode for providing a content only to a user positioned in the passenger seat of the vehicle depending on a condition or an input.

In the embodiment, a size of each of the first area 710 and the second area 720 can be previously designated. For example, the first area 710 can be previously designated with a size smaller or larger than that of the second area 720. For another example, each of the first area 710 and the second area 720 can correspond to 50% of a size of the display area.

In one embodiment, a gate driver 730 can be disposed on one side of the display area. The gate driver 730 can correspond to the gate driver GD of FIG. 1. In some cases, the gate driver 730 can be arranged on at least one side of the display area. For example, the gate driver 730 can be disposed on at least one of an upper side, a lower side, a left side or a right side of the display area. In another embodiment, the gate driver 730 can be disposed on both sides of the display area.

In the embodiment, a pixel circuit can be disposed in each of the first area 710 and the second area 720. For example, a first pixel circuit can be disposed in the first area 710, and a second pixel circuit can be disposed in the second area 720. The first pixel circuit and the second pixel circuit can receive a signal for driving a light emitting element from the gate driver 730. This will be described later in more detail.

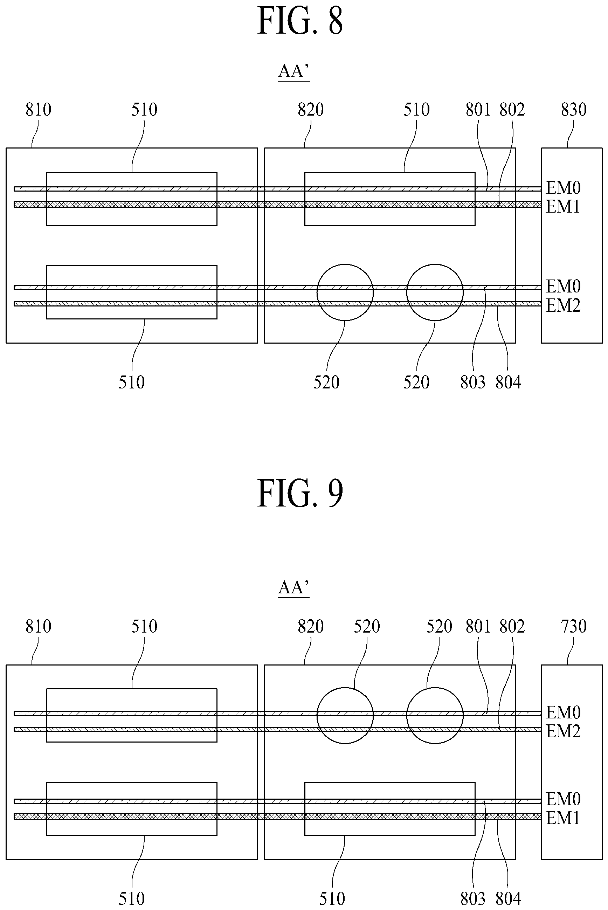

A lens for controlling a moving direction of light of the light emitting element can be disposed on the first pixel circuit and the second pixel circuit. The arrangement of the lens will be described with reference to FIGS. 8 to 10 based on the line AA' crossing the first area 710 and the second area 720.

FIGS. 8 and 9 are views illustrating an example of arrangement of a lens included in a display apparatus according to the embodiment of the present disclosure.

FIG. 8 illustrates a first subpixel area 810 disposed on the line AA' in a first area (e.g., the first area 710 of FIG. 7) of FIG. 7, a second subpixel area 820 disposed on the line AA' in a second area (e.g., the second area 720 of FIG. 7) of FIG. 7 and a gate driving circuit 830 (at least a portion of the gate driving circuit 710 of FIG. 7) for providing a gate signal to the first subpixel area 810 and the second subpixel area 820.

In more detail, a first pixel area (included in the first area), which includes a plurality of subpixels, and a second pixel area (included in the second area), which includes a plurality of subpixels, can be disposed on the line AA'. For convenience of description, FIG. 8 illustrates the first subpixel area 810 corresponding to one subpixel among a plurality of subpixels disposed in the first pixel area and the second subpixel area 820 corresponding to one subpixel among a plurality of subpixels disposed in the second pixel area.

Referring to FIG. 8, the first pixel circuit and two first lenses 510 disposed on the first pixel circuit can be disposed in the first subpixel area 810. The second pixel circuit and one first lens 510 and two second lenses 520, which are disposed on the second pixel circuit, can be disposed in the second subpixel area 820.

In one embodiment, the size of the first lens 510, which is connected to a second line 802, among the lenses disposed in the first subpixel area 810 can be different from that of the first lens 510 connected to a fourth line 804. For example, the sizes of the first lens 510 and the third lens, which are connected to the second line 802, can be different from each other. For example, the size of the first lens 510 can be greater than that of the first lens 510 connected to the fourth line 804.

In one embodiment, a lens, which shares the gate line with the second lens 520, among the first lenses 510 disposed in the first subpixel area 810, for example, the first lens 510 connected to the first line 801 and the second line 802 can have a size smaller than that of another first lens 510. In this case, another first lens 510 can include a lens that shares the gate line with the first lens 510 disposed in the second subpixel area 820. A lens, which shares the gate line with the second lens 520, among the first lenses 510 disposed in the first subpixel area 810 can be determined to have a size based on light condensing efficiency of the second lens 520. For example, when the light condensing efficiency of the second lens 520 is higher than that of the first lens 510, the lens sharing the gate line with the second lens 520 can have a size downsized in inverse proportion to the light condensing efficiency.

In the embodiment, when the first lenses 510 disposed in the first subpixel area 810 are formed to have different sizes, center lines of the first lenses 510 can be disposed to be matched with each other. For example, center points of the first lenses 510 disposed in the first subpixel area 810 can be disposed in the first subpixel area 810 to be included in the same column.

In the embodiment, the first pixel circuit of the first subpixel area 810 can include a first light emitting element and a second light emitting element. The first lenses 510 can be disposed on each of the first light emitting element and the second light emitting element. The second pixel circuit of the second subpixel area 820 can include a third light emitting element and a fourth light emitting element. The first lens 510 can be disposed on the third light emitting element, and the second lenses 520 can be disposed on the fourth light emitting element.

In the embodiment, the first pixel circuit including a first light emitting element and the second pixel circuit including a third light emitting element can be provided with a common light emission signal EM0 and a first light emission signal EM1 from the gate driver 830. For example, the first pixel circuit including a first light emitting element and the second pixel circuit including a third light emitting element can receive the common light emission signal EM0 from the gate driver 830 through the first line 801 and receive the first light emission signal EM1 from the gate driver 830 through the second line 802 in response to driving of the first mode to allow the first and third light emitting elements to emit light. The first subpixel area 810 can provide a viewing angle of the first mode through the first lens 510 disposed on the first light emitting element. The second subpixel area 820 can provide a viewing angle of the first mode through the first lens 510 disposed on the third light emitting element.

In this case, the first mode can correspond to a mode in which a content is commonly provided to the driver and the passenger of the vehicle. In the first mode, the same content can be displayed to the driver and the passenger. Therefore, the driver and the passenger can use the content displayed through the display apparatus at the same time. According to one embodiment, the first mode can be referred to as a sharing mode or a share mode, but is not limited thereto.

In the embodiment, the first pixel circuit including a second light emitting element and the second pixel circuit including a fourth light emitting element can be provided with a common light emission signal EM0 and a second light emission signal EM2 from the gate driver 830. For example, the first pixel circuit including a second light emitting element and the second pixel circuit including a fourth light emitting element can receive the common light emission signal EM0 from the gate driver 830 through the third line 803 and receive the second light emission signal EM2 from the gate driver 830 through the fourth line 804 in response to driving of the second mode to allow the second and fourth light emitting elements to emit light. The first subpixel area 810 can provide a viewing angle of the first mode through the first lens 510 disposed on the second light emitting element. The second subpixel area 820 can provide a viewing angle of the second mode through the second lenses 520 disposed on the fourth light emitting element.

Meanwhile, the first subpixel area 810 in which the second light emitting element is disposed can provide light at a viewing angle of the first mode through the first lens 510 as the second light emitting element is driven even though the light emission signal (e.g., the common light emission signal EM0 and the second light emission signal EM2) of the second mode is provided. The second subpixel area 820 on which the fourth light emitting element is disposed can provide light at a viewing angle of the second mode through the second lenses 520 as the fourth light emitting element is driven in response to the light emission signal (e.g., the common light emission signal EM0 and the second light emission signal EM2) of the second mode.

In other words, since the first lens 510 is disposed on the second light emitting element and the second lenses 520 are disposed on the fourth light emitting element, the viewing angle of the second subpixel area 820 in which the fourth light emitting element is disposed can be narrower than the viewing angle of the first subpixel area 810. In this case, even though the light emission signal of the second mode is commonly provided to the first and second subpixel areas 810 and 820, the first subpixel area 810 can provide light (or content provided from the second light emitting element) to both the driver and the passenger through the first lens 510. That is, the first subpixel area 810 can operate in the first mode for providing light at the viewing angle of the first mode. However, the second subpixel area 820 can provide light (or content) provided from the fourth light emitting element to the passenger through the second lenses 520 but can be limited so as not to be provided to the driver. That is, in response to the driving of the second mode, the first subpixel area 810 can provide light at the viewing angle of the first mode, and the second subpixel area 820 can provide light at the viewing angle of the second mode.

The first subpixel area 810 can provide light at the viewing angle of the first mode through the first lens 510 as the first light emitting element is driven when the light emission signal of the first mode is supplied and the second light emitting element is driven when the light emission signal of the second mode is supplied. Therefore, the first and second light emitting elements of the first subpixel area 810 are alternately driven, so that degradation can be reduced and lifespan can be extended.

In this case, the second mode can correspond to a mode in which a driver and a passenger of a vehicle are distinguished from each other to provide them with a respective content. In the second mode, different contents can be displayed to the driver and the passenger, respectively. Alternatively, in the second mode, the display of the content can be limited to the driver, and the content can be displayed only to the passenger. In the second mode, contents that can be recognized by each of the driver and the passenger through the display apparatus can be distinguished. That is, the contents of the first subpixel area 810 can be recognized by the driver, and the contents of the first subpixel area 810 and the second subpixel area 820 can be recognized by the passenger. According to the embodiment, the second mode can be referred to as a protective mode, an individual mode or a privacy mode, but is not limited thereto.

According to the present embodiment, the display apparatus (or display panel) displays essential contents related to driving in the first subpixel area 810 in response to driving of the second mode and limits contents (e.g., entertainment content that can disturb driving) of the second subpixel area 820 to the driver, thereby improving driving concentration of the driver for more safely driving. In addition, the display apparatus allows the passenger to recognize the contents displayed on the second subpixel area 820 so that the passenger can freely use the display apparatus, thereby improving usability of the display apparatus.

FIG. 8 illustrates an example in which the first lens 510 is disposed above the second lens 520 in the second subpixel area 820, but is not limited thereto. Another example of the arrangement of the first lens 510 and the second lens 520 with respect to the second subpixel area 820 will be described with reference to FIG. 9.

In the embodiment, the first line 801 and the third line 803 can be lines that provide the same signal. In this case, the first line 801 and the third line 803 can be connected to each other, but are not limited thereto, and can be formed as separate lines.

FIG. 9 illustrates a first subpixel area 810 disposed on the line AA' in the first area (e.g., the first area 710 of FIG. 7) of FIG. 7, a second subpixel area 820 disposed on the line AA' in the second area (e.g., the second area 720 of FIG. 7) of FIG. 7 and a gate driving circuit 830 (at least a portion of the gate driving circuit 710 of FIG. 7) for providing a gate signal to the first subpixel area 810 and the second subpixel area 820. The description of FIG. 9 that is redundant with the description of FIG. 8 will be omitted.

Referring to FIG. 9, the second lens 520 of the second subpixel area 820 can be disposed above the first lens 510.

In one embodiment, the second lens 520 is disposed on the third light emitting element of the second pixel circuit disposed in the second subpixel area 820, and the first lens 510 can be disposed on the fourth light emitting element of the second pixel circuit.

The first pixel circuit including a first light emitting element in the first subpixel area 810 and the second pixel circuit including a third light emitting element in the second subpixel area 820 can receive the common light emission signal EM0 and the second light emission signal EM2 from the gate driver 830. For example, the first pixel circuit including a first light emitting element and the second pixel circuit including a third light emitting element can receive the common light emission signal EM0 and the second light emission signal EM2 from the gate driver 830 through the first and second lines 801 and 802 in response to driving of the second mode.

The first pixel circuit including a second light emitting element in the first subpixel area 810 and the second pixel circuit including a fourth light emitting element in the second subpixel area 820 can receive the common light emission signal EM0 and the first light emission signal EM1 from the gate driver 830. For example, the first pixel circuit including a first light emitting element and the second pixel circuit including a fourth light emitting element can receive the common light emission signal EM0 and the first light emission signal EM1 from the gate driver 830 through the third and fourth lines 803 and 804 in response to driving of the first mode.

The first mode can correspond to a mode in which a content is commonly provided to the driver and the passenger of the vehicle, as described above. The second mode can correspond to a mode in which the driver and the passenger of the vehicle are distinguished from each other to provide them with a respective content.

In another embodiment, the first lens 510 can be disposed on the second light emitting element, and the second lens 520 can be disposed on the fourth light emitting element. In this case, the second light emitting element can be disposed above the fourth light emitting element.

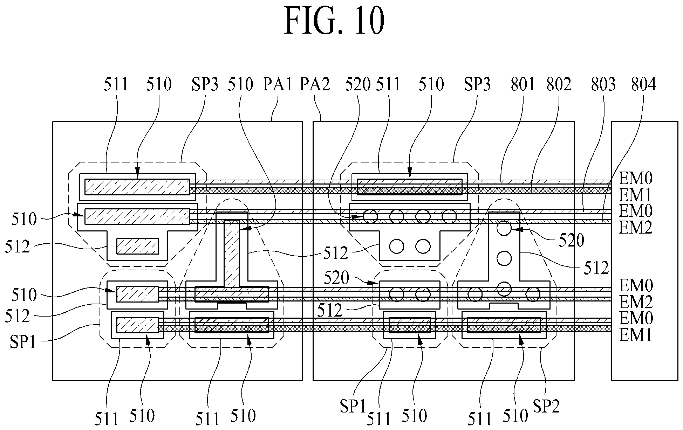

In FIGS. 8 and 9, one first lens 510 is disposed on one light emitting element, and two second lenses 520 are disposed on one light emitting element, but the present disclosure is not limited thereto. A plurality of first lenses 510 can be disposed on one light emitting element or three or more second lenses 520 can be disposed on one light emitting element. This will be described in more detail with reference to FIG. 10.

FIG. 10 is a view illustrating an example of arrangement of a lens and a pixel area, which are included in a display apparatus according to the embodiment of the present disclosure. In FIG. 10, X-axis can correspond to a pixel row, and Y-axis can correspond to a pixel column. In FIG. 10, two pixel areas PA1 and PA2 arranged in different columns of one pixel row are shown as an example, but the present disclosure is not limited thereto, and three or more pixel areas can be disposed in one pixel row

Referring to FIG. 10, a plurality of pixel areas can be disposed in one pixel row. For example, a first pixel area PA1 and a second pixel area PA2 can be disposed in an (n)th pixel row. A plurality of subpixels SP1, SP2 and SP3, which emit light of their respective colors, for example, a blue subpixel, a green subpixel and a red subpixel can be disposed in each of the first pixel area PA1 and the second pixel area PA2.

In the embodiment, the first pixel area PA1 can be included in the first area 710 (FIG. 7), and the second pixel area PA2 can be included in the second area 720 (FIG. 7). The first pixel area PA1 can correspond to an area disposed to be adjacent to a driver's seat of a vehicle. The second pixel area PA2 can correspond to an area disposed to be adjacent to a passenger seat of the vehicle

In the embodiment, when a pixel area (e.g., the pixel area PA of FIG. 1) includes three subpixels, subpixels, which emit light of the same color, among subpixels disposed in different columns of the same row can be connected to the same line as that of the gate driving circuit 101. For example, the first subpixel SP1 of the first pixel area PA1 can be connected to the first subpixel SP1 of the second pixel area PA2. The second subpixel SP2 of the first pixel area PA1 can be connected to the second subpixel SP2 of the second pixel area PA2. The third subpixel SP3 of the first pixel area PA1 can be connected to the third subpixel SP3 of the second pixel area PA2.

In one embodiment, the pixel area can include a subpixel area corresponding to each of the plurality of subpixels. The subpixel area can include a lens area corresponding to each of the light emitting elements included in the subpixel. The lens area can include a light emitting element and a lens disposed on the light emitting element.

In one embodiment, one lens area can include a plurality of lenses. That is, the plurality of lenses can be disposed on one light emitting element. Referring to FIG. 10, the third subpixel SP3 of the first pixel area PA1 can include a first lens area 511 and a second lens area 512. The first lens 510 can be disposed in the first lens area 511 included in the third subpixel SP3 of the first pixel area PA1, and two first lenses 510 can be disposed in the second lens area 512. The first lenses 510 disposed in the second lens area 512 can have different sizes, but are not limited thereto. The third subpixel SP3 of the second pixel area PA2 can include a first lens area 511 and a second lens area 512. One first lens 510 can be disposed in the first lens area 511 included in the third subpixel SP3 of the second pixel area PA2, and six second lenses 520 can be disposed in the second lens area 512.

The subpixels emitting light of the same color, for example, the third subpixel SP3 of the first pixel area PA1 and the third subpixel SP3 of the second pixel area PA2 can be connected to the same gate line. For example, the first pixel circuit including a first light emitting element and the second pixel circuit including a third light emitting element can be connected to the first line 801 and the second line 802 of the gate driver 101 when the third subpixel SP3 of the first pixel area PA1 includes a first light emitting element and a second light emitting element and the third subpixel SP3 of the second pixel area PA2 includes a third light emitting element and a fourth light emitting element. The first line 801 and the second line 802 can supply the common light emission signal EM0 and the first light emission signal EM1. The first pixel circuit including a second light emitting element and the second pixel circuit including a fourth light emitting element can be connected to the third line 803 and the fourth line 804 of the gate driver 101. The third line 803 and the fourth line 804 can supply the common light emission signal EM0 and the second light emission signal EM2,

In the embodiment, a position of the light emitting element in which the first lens 510 is disposed and a position of the light emitting element in which the second lens 520 is disposed can be previously designated in the subpixel disposed in the second area. For example, in the first subpixel SP1 of the second pixel area PA2, the first lens 510 and the light emitting element in which the first lens 510 is disposed can be disposed below the second lens 520 and the light emitting element in which the second lens 520 is disposed. In the third subpixel SP3 of the second pixel area PA2, the first lens 510 and the light emitting element in which the first lens 510 is disposed can be disposed above the second lens 520 and the light emitting element in which the second lens 520 is disposed.

In the embodiment, the number and size of lenses disposed in the subpixels SP1, SP2 and SP3 can be determined by at least one of a shape or area of the subpixels SP1, SP2 and SP3. For example, when sizes of the lens areas corresponding to the respective light emitting elements in which the first lens 510 is disposed are different from each other in the third subpixel SP3 of the first pixel area PA1, the number of the first lenses can be different correspondingly, or the sizes of the first lenses can be different correspondingly. However, the area and size of the lens do not limit the function of the lens, that is, the control of the viewing angle.

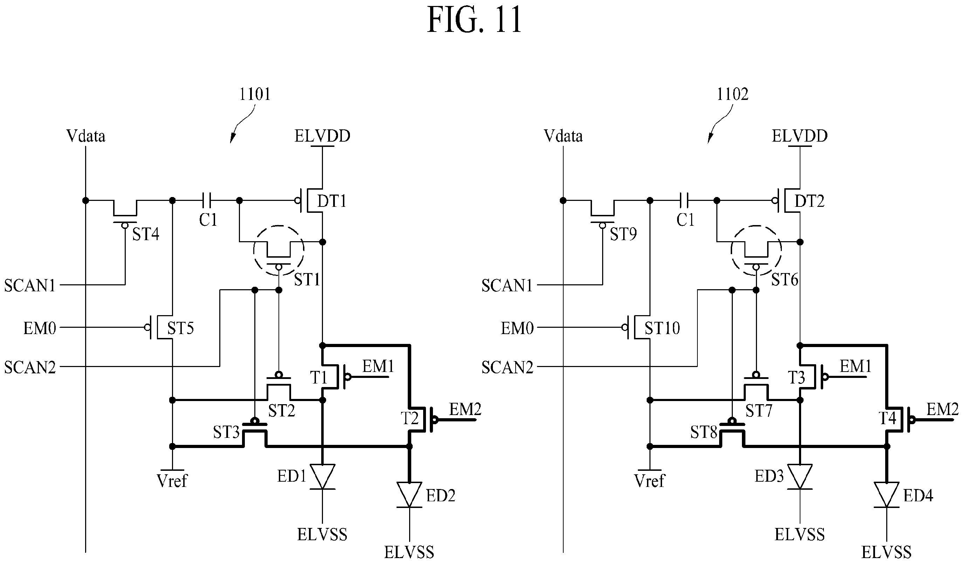

FIG. 11 is a view illustrating an example of a pixel circuit of a display apparatus according to the embodiment of the present disclosure. In detail, FIG. 11 illustrates an example of a first pixel circuit 1101 included in a first area operating in a first mode and a second pixel circuit 1102 included in a second area operating in a first mode or a second mode.

Referring to FIG. 11, structures of the first pixel circuit 1101 and the second pixel circuit 1102 can correspond to each other. Components included in the first pixel circuit 1101 can be the same as those included in the second pixel circuit 1102. Hereinafter, the first pixel circuit 1101 and the second pixel circuit 1102 of FIG. 11 will be described by corresponding to FIG. 8.

In the embodiment, the first pixel circuit 1101 can include a first driving transistor DT1, a first transistor T1 receiving a first light emission signal EM1 from the gate driving circuit, a second transistor T2 receiving a second light emission signal EM2 from the gate driving circuit, a first light emitting element ED1 connected to the first transistor T1, and a second light emitting element ED2 connected to the second transistor T2. The first transistor T1 and the second transistor T2 can be represented by a first emission control transistor T1 and a second emission control transistor T2, respectively.

In the embodiment, a first electrode of the first driving transistor DT1 can be connected to a high potential power line to receive a high potential voltage ELVDD from a power supply unit. A second electrode of the first driving transistor DT1 can be connected to the first transistor T1 that receives the first light emission signal EM1 from the gate driving circuit, and can be connected to the second transistor T2 that receives the second light emission signal EM2.

In the embodiment, the second electrode of the first driving transistor DT1 can be connected to a first scan transistor ST1. A gate electrode of the first driving transistor DT1 can be connected to a first capacitor C1.

In the embodiment, the first capacitor C1 can include a storage capacitor for maintaining a constant voltage for one frame. The first capacitor C1 can be connected between the first driving transistor DT1 and a fourth scan transistor ST4 to uniformly maintain a data voltage Vdata supplied through the fourth scan transistor ST4 for one frame. The first capacitor C1 can uniformly maintain a gate-source voltage Vgs of the first driving transistor DT1 for one frame.

According to the embodiment, the first capacitor C1 can maintain a constant voltage for two or more frames. In this case, the first capacitor C1 can uniformly maintain the gate-source voltage Vgs of the first driving transistor DT1 for two or more frames.

In the embodiment, a first electrode of the first scan transistor ST1 can be connected to the gate electrode of the first driving transistor DT1. The second electrode of the first scan transistor ST1 can be connected to the second electrode of the first driving transistor DT1. A gate electrode of the first scan transistor ST1 can be connected to a second scan line that provides a second scan signal SCAN2. The first scan transistor ST1 can receive the second scan signal SCAN2 from the gate driving circuit through the second scan line.

The gate electrode of the first scan transistor ST1 can be connected to a gate electrode of each of a second scan transistor ST2 and a third scan transistor ST3. The gate electrode of each of the second scan transistor ST2 and the third scan transistor ST3 can be connected to the second scan line that provides the second scan signal SCAN2. In this case, the first scan transistor ST1, the second scan transistor ST2 and the third scan transistor ST3 can be turned on or off by the second scan signal SCAN2.

In the embodiment, a first electrode of the second scan transistor ST2 can be connected to the first transistor T1 and the first light emitting element ED1. For example, the first electrode of the second scan transistor ST2 can be connected to a second electrode of the first transistor T1 and an anode electrode of the first light emitting element ED1. A second electrode of the second scan transistor ST2 can be provided with a reference voltage Vref from a reference voltage supply unit through a reference voltage supply line.

In the embodiment, a first electrode of the third scan transistor ST3 can be connected to the second transistor T2 and the second light emitting element ED2. For example, the first electrode of the third scan transistor ST3 can be connected to a second electrode of the second transistor T2 and an anode electrode of the second light emitting element ED2. A second electrode of the third scan transistor ST3 can be provided with the reference voltage Vref from the reference voltage supply unit through the reference voltage supply line.

In the embodiment, a fourth scan transistor ST4 can be connected to the first capacitor C1, a fifth scan transistor ST5 and a data voltage supply line. A first electrode of the fourth scan transistor ST4 can be connected to the first capacitor C1 and/or the fifth scan transistor ST5. A second electrode of the fourth scan transistor ST4 can be connected to the data voltage supply line. A gate electrode of the fourth scan transistor ST4 can receive a first scan signal SCAN1 from the gate driving circuit through a first scan line. The fourth scan transistor ST4 can be turned on/off by the first scan signal SCAN1. When the fourth scan transistor ST4 is turned on, a data voltage can be provided to the first capacitor C1.

In the embodiment, a first electrode of the fifth scan transistor ST5 can be connected to the fourth scan transistor ST4 and/or the first capacitor C1. A second electrode of the fifth scan transistor ST5 can be provided with the reference voltage Vref from the reference voltage supply unit through the reference voltage supply line.

In the embodiment, the first pixel circuit 1101 can further include a transistor for receiving a common light emission signal. For example, the first pixel circuit 1101 can further include a fifth scan transistor ST5 that receives a common light emission signal. A gate electrode of the fifth scan transistor ST5 can be supplied with a common light emission signal EM0 from the gate driving circuit through a common light emission signal line (e.g., the first line 801 of FIG. 8). The fifth scan transistor ST5 can be turned on or off by the common light emission signal EM0.

In the embodiment, the first transistor T1 can be connected between the first driving transistor DT1 and the first light emitting element ED1. A gate electrode of the first transistor T1 can be connected to a first light emission signal line (e.g., the second line 802 of FIG. 8) to receive a first light emission signal EM1. The first transistor T1 can be turned on or off by the first light emission signal EM1. For example, the first transistor T1 can be turned on in response to the supply of the first light emission signal EM1. In this case, the first light emitting element ED1 and the first driving transistor DT1 can be connected to each other.

In the embodiment, the second transistor T2 can be connected between the first driving transistor DT1 and the second light emitting element ED2. A gate electrode of the second transistor T2 can be connected to a second light emission signal line (e.g., the fourth line 804 of FIG. 8) to receive a second light emission signal EM2. The second transistor T2 can be turned on or off by the second light emission signal EM2. For example, the second transistor T2 can be turned on in response to the supply of the second light emission signal EM2. In this case, the second light emitting element ED2 and the first driving transistor DT1 can be connected to each other.

In the embodiment, a cathode electrode of the first light emitting element ED1 can receive a low potential voltage ELVSS from the power supply unit through a low potential voltage supply line. The first light emitting element ED1 can be connected to the first driving transistor DT1 in response to the first transistor T1 that is turned on. In this case, the first light emitting element ED1 can receive a voltage from the first driving transistor DT1 to emit light.

In the embodiment, a cathode electrode of the second light emitting element ED2 can receive the low potential voltage ELVSS from the power supply unit through the low potential voltage supply line. The second light emitting element ED2 can be connected to the first driving transistor DT1 in response to the second transistor T2 that is turned on. In this case, the second light emitting element ED2 can receive a voltage from the first driving transistor DT1 to emit light.

In the embodiment, the second pixel circuit 1102 can include a second driving transistor DT2, a third transistor T3 receiving the first light emission signal EM1 from the gate driving circuit, a fourth transistor T4 receiving the second light emission signal EM2 from the gate driving circuit, a third light emitting element ED3 connected to the third transistor T3, and a fourth light emitting element ED4 connected to the fourth transistor T4. The third transistor T3 and the fourth transistor T4 can be represented by a third emission control transistor T3 and a second emission control transistor T4, respectively.

In the embodiment, a first electrode of the second driving transistor DT2 can be connected to a high potential power line to receive a high potential voltage ELVDD from the power supply unit. A second electrode of the second driving transistor DT2 can be connected to the third transistor T3 that receives the first light emission signal EM1 from the gate driving circuit, and can be connected to the fourth transistor T4 that receives the second light emission signal EM2.

In the embodiment, the second electrode of the first driving transistor DT1 can be connected to the first scan transistor ST1. The gate electrode of the first driving transistor DT1 can be connected to a second capacitor C2

In one embodiment, the second capacitor C2 can include a storage capacitor for maintaining a constant voltage for one frame. The second capacitor C2 can be connected between the second driving transistor DT2 and a ninth scan transistor ST9 to uniformly maintain the data voltage Vdata supplied through the ninth scan transistor ST9 for one frame. The second capacitor C2 can uniformly maintain the gate-source voltage Vgs of the second driving transistor DT2 for one frame.

In the embodiment, the data voltage Vdata supplied to the ninth scan transistor ST9 can correspond to the data voltage Vdata supplied to the fourth scan transistor ST4 of the first pixel circuit 1101. Although not shown, a data line for supplying the data voltage Vdata to the ninth scan transistor ST9 and a data line for supplying the data voltage Vdata to the fourth scan transistor ST4 can be at least partially connected to each other.

In the embodiment, a first electrode of a sixth scan transistor ST6 can be connected to a gate electrode of the second driving transistor DT2. A second electrode of the sixth scan transistor ST6 can be connected to a second electrode of the second driving transistor DT2. A gate electrode of the sixth scan transistor ST6 can be connected to a second scan line that provides the second scan signal SCAN2. The sixth scan transistor ST6 can receive the second scan signal SCAN2 from the gate driving circuit through the second scan line.

The gate electrode of the sixth scan transistor ST6 can be connected to a gate electrode of each of a seventh scan transistor ST7 and an eighth scan transistor ST8. The gate electrode of each of the seventh scan transistor ST7 and the eighth scan transistor ST8 can be connected to the second scan line that provides the second scan signal SCAN2. In this case, the sixth scan transistor ST6, the seventh scan transistor ST7 and the eighth scan transistor ST8 can be turned on or off by the second scan signal SCAN2.

In the embodiment, a first electrode of the seventh scan transistor ST7 can be connected to the third transistor T3 and the third light emitting element ED3. For example, the first electrode of the seventh scan transistor ST7 can be connected to a second electrode of the third transistor T3 and an anode electrode of the third light emitting element ED3. A second electrode of the seventh scan transistor ST7 can be provided with the reference voltage Vref from the reference voltage supply unit through the reference voltage supply line.

In the embodiment, a first electrode of the eighth scan transistor ST8 can be connected to the fourth transistor T4 and the fourth light emitting element ED4. For example, the first electrode of the eighth scan transistor ST8 can be connected to a second electrode of the fourth transistor T4 and an anode electrode of the fourth light emitting element ED4. A second electrode of the eighth scan transistor ST8 can be provided with the reference voltage Vref from the reference voltage supply unit through the reference voltage supply line.

In the embodiment, the ninth scan transistor ST9 can be connected to the second capacitor C2, a tenth scan transistor ST10 and the data voltage supply line. A first electrode of the ninth scan transistor ST9 can be connected to the second capacitor C2 and/or the tenth scan transistor ST10. A second electrode of the ninth scan transistor ST9 can be connected to the data voltage supply line. A gate electrode of the ninth scan transistor ST9 can receive the first scan signal SCAN1 from the gate driving circuit through the first scan line. The ninth scan transistor ST9 can be turned on/off by the first scan signal SCAN1. When the ninth scan transistor ST9 is turned on, the data voltage can be provided to the second capacitor C2.

In the embodiment, a first electrode of the tenth scan transistor ST10 can be connected to the ninth scan transistor ST9 and/or the second capacitor C2. A second electrode of the tenth scan transistor ST10 can be provided with the reference voltage Vref from the reference voltage supply unit through the reference voltage supply line.

In the embodiment, the second pixel circuit 1102 can further include a transistor for receiving a common light emission signal. For example, the second pixel circuit 1102 can further include a tenth scan transistor ST10 that receives a common light emission signal. A gate electrode of the tenth scan transistor ST10 can be supplied with the common light emission signal EM0 through the common light emission signal line (e.g., the first line 801 of FIG. 8) from the gate driving circuit. The tenth scan transistor ST10 can be turned on or off by the common light emission signal EM0.

In the embodiment, the third transistor T3 can be connected between the second driving transistor DT2 and the third light emitting element ED3. A gate electrode of the third transistor T3 can be connected to the first light emission signal line (e.g., the second line 802 of FIG. 8) to receive the first light emission signal EM1. The third transistor T3 can be turned on or off by the first light emission signal EM1. For example, the third transistor T3 can be turned on in response to the supply of the first light emission signal EM1. In this case, the third light emitting element ED3 and the second driving transistor DT2 can be connected to each other.

In the embodiment, the fourth transistor T4 can be connected between the second driving transistor DT2 and the fourth light emitting element ED4. A gate electrode of the fourth transistor T4 can be connected to the second light emission signal line (e.g., the fourth line 804 of FIG. 8) to receive the second light emission signal EM2. The fourth transistor T4 can be turned on or off by the second light emission signal EM2. For example, the fourth transistor T4 can be turned on in response to the supply of the second light emission signal EM2. In this case, the fourth light emitting element ED4 and the second driving transistor DT2 can be connected to each other.

In the embodiment, a cathode electrode of the third light emitting element ED3 can receive the low potential voltage ELVSS from the power supply unit through the low potential voltage supply line. The third light emitting element ED3 can be connected to the third driving transistor DT3 in response to the third transistor T3 that is turned on. In this case, the third light emitting element ED3 can receive a voltage from the third driving transistor DT3 to emit light.

In the embodiment, a cathode electrode of the fourth light emitting element ED4 can receive the low potential voltage ELVSS from the power supply unit through the low potential voltage supply line. The fourth light emitting element ED4 can be connected to the second driving transistor DT2 in response to the fourth transistor T4 that is turned on. In this case, the fourth light emitting element ED4 can receive a voltage from the second driving transistor DT2 to emit light.

According to the embodiment, the third transistor T3 connected to the third light emitting element ED3 of the second pixel circuit 1102 can be connected to a line for providing the second light emission signal EM2, and the fourth transistor T4 connected to the fourth light emitting element ED4 can be connected to a line for providing the first light emission signal EM1. That is, the transistors T3 and T4 connected to the light emitting elements can be alternately connected to the light emission signals EM1 and EM2 unlike FIG. 11. In this case, the embodiment of FIG. 9 can be implemented, but this is only exemplary and does not limit the embodiment of FIG. 9.

In the embodiment, at least a portion of the transistors (e.g., the first driving transistor DT1, the first scan transistor ST1 to the tenth scan transistor ST10, the first transistor T1 and the second transistor T2) included in the first pixel circuit 1101 and the second pixel circuit 1102 can be an n-type transistor or a p-type transistor. In case of the p-type transistor, a low level voltage of each driving signal can mean a voltage for turning on TFTs, and a high level voltage of each driving signal can mean a voltage for turning off the TFTs.

In this case, the low level voltage can correspond to a predesignated voltage lower than the high level voltage. For example, the low level voltage can include a voltage corresponding to a range of -8V to -12V. The high level voltage can correspond to a predesignated voltage higher than the low level voltage. For example, the high level voltage can include a voltage corresponding to a range of 6V to 8V. According to the embodiment, the low level voltage can be referred to as a first voltage, and the high level voltage can be referred to as a second voltage. In this case, the first voltage can be a value lower than the second voltage.

In the embodiment, the first light emission signal EM1 and the second light emission signal EM2 can be provided to at least one of the first pixel circuit 1101 or the second pixel circuit 1102 in accordance with an input related to a mode control of at least one of the first area or the second area. For example, the first light emission signal EM1 can be provided to the first pixel circuit 1101 and the second pixel circuit 1102 in response to an input that causes an operation of the first mode or satisfying a first condition (predesignated condition). The second light emission signal EM2 can be provided to the first pixel circuit 1101 and the second pixel circuit 1102 in response to an input that causes an operation of the second mode or satisfying a second condition (predesignated condition distinguished from the first condition). In response to the first light emission signal EM1 or the second light emission signal EM2, the first light emitting element ED1 and the third light emitting element ED3 can emit light or the second light emitting element ED2 and the fourth light emitting element ED4 can emit light.

In the embodiment, the first light emitting element ED1, the second light emitting element ED2, the third light emitting element ED3 and/or the fourth light emitting element ED4 can be an organic light emitting element, an inorganic light emitting element, or a quantum dot light emitting element. When the light emitting element (e.g., the first light emitting element ED1, the second light emitting element ED2, the third light emitting element ED3 or the fourth light emitting element ED4) is an organic light emitting element, a light emitting layer of the light emitting element can include an organic light emitting layer containing an organic material.

In the embodiment, at least one lens can be disposed on each of the first light emitting element ED1, the second light emitting element ED2, the third light emitting element ED3 and the fourth light emitting element ED4. In one embodiment, at least three first lenses can be disposed on the first light emitting element ED1, the second light emitting element ED2 and the third light emitting element ED3. At least one second lens can be disposed on the fourth light emitting element ED4. For example, a first lens can be disposed on each of the first light emitting element ED1, the second light emitting element ED2 and the third light emitting element ED3. As shown in FIG. 8, two second lenses can be disposed on the fourth light emitting element ED4.

In one embodiment, a plane of the first lens can correspond to a rectangle extended in one direction. A plane of the second lens can correspond to a circle. A cross-section of each of the first lens and the second lens can correspond to a semicircular shape. A size of the second lens can be greater than a light emitting area of the fourth light emitting element ED4. For example, the second lens can be disposed to cover the fourth light emitting element ED4.

The first lens can include a lens for controlling a moving direction of light to be in a first direction and a second direction. The second lens can include a lens for controlling the moving direction of the light to be in the first direction.

A viewing angle of an area corresponding to the light emitting element (e.g., the first light emitting element ED1, the second light emitting element ED2 and the third light emitting element ED3) in which the first lens is disposed can have a first value. A viewing angle of an area corresponding to the light emitting element (e.g., the fourth light emitting element ED4) in which the second lens is disposed can have a second value (smaller than the first value).

In the embodiment, the gate driving circuit (not shown) can provide the first light emission signal EM1 in response to driving of the first mode, and can provide the second light emission signal EM2 in response to driving of the second mode. When the first mode is driven, the first light emission signal EM1 can be provided, and when the second mode is driven, the second light emission signal EM2 can be provided.

In this case, since the first lenses are disposed in the first area in which the first pixel circuit 1101 is disposed, the first area can maintain the first mode regardless of the driving of the first mode or the second mode. That is, the first area can have a viewing angle of a first value regardless of the driving of the first mode or the second mode. The second area can have a viewing angle corresponding to the first value in response to the driving of the first mode, and can have a viewing angle corresponding to the second value in response to the driving of the second mode. The second area can be driven in the first mode in response to the driving of the first mode, and can be driven in the second mode in response to the driving of the second mode. In this case, since the viewing angle of the second mode becomes narrower than that of the first mode, no content can be provided to a user of the driver's seat positioned to be farther than a predetermined distance from the second area, that is, the driver. On the other hand, the content can be provided to a user positioned in a passenger seat positioned to be closer than a predetermined distance from the second area, that is, a passenger.

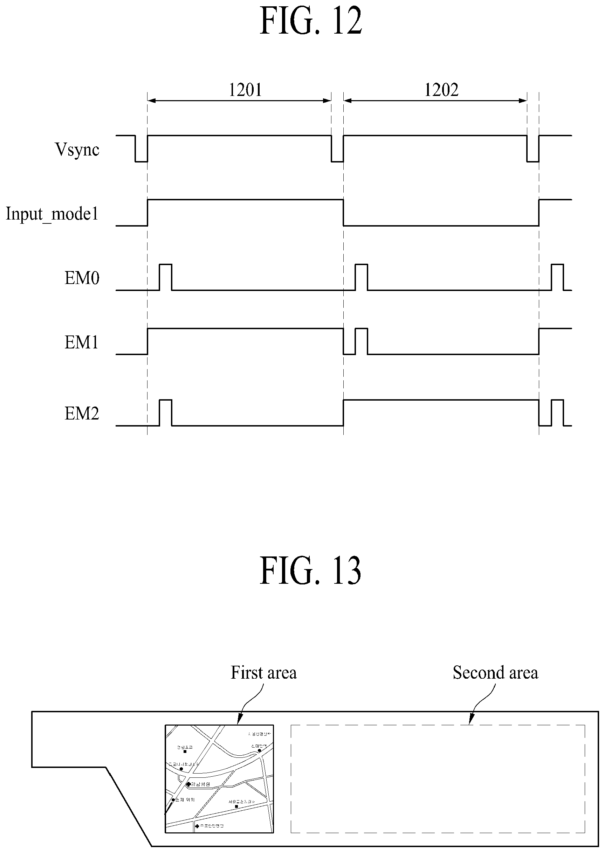

FIG. 12 is a view illustrating an example of a signal flow of a display apparatus according to the embodiment of the present disclosure. FIG. 12 is an exemplary view illustrating a flow of signals provided to the first pixel circuit 1101 and the second pixel circuit 1102 of the display apparatus according to the embodiment of FIG. 11.

Referring to FIG. 12, a timing controller can generate a gate control signal for controlling a gate driver based on a vertical synchronization signal Vsync having a predetermined period. As shown, the vertical synchronization signal Vsync can include an active period (e.g., a first active period 1201 and a second active period 1202) of each frame and a non-active period between the active periods 1201 and 1202.

The timing controller can control the gate driver by generating a mode control signal Input_mode1 and a gate control signal based on the vertical synchronization signal Vsync. The gate driver can generate a common light emission signal EM0, a first light emission signal EM1 and a second emission control EM2 based on the mode control signal Input_mode1 and the gate control signal to supply the generated first light emission signal EM0, the first light emission signal EM1 and the second emission signal EM2 to the pixel circuits disposed in the display panel.

In the embodiment, the gate driver can receive, from the timing controller, the mode control signal Input_mode1 in a second mode state Mode2 at the first active period 1201, and can receive the mode control signal Input_mode1 in a first mode state at the second active period 1202. The case that the mode control signal Input_mode1 is applied in the first or second mode state can include, for example, a case that a first condition (e.g., when the vehicle is stopped) is satisfied or a case that an input is applied from a user.

In the embodiment, the gate driver can generate the common light emission signal EM0 regardless of the level of the mode control signal Input_mode1 and provide the generated common light emission signal EM0 to the pixel circuits (e.g., the first pixel circuit and the second pixel circuit) disposed on the display panel. For example, the common light emission signal EM0 can be generated at each of the active periods 1201 and 1202 of each frame and applied to the pixel circuit. A timing point when the common light emission signal EM0 is applied can be previously designated.

In the embodiment, the gate driver can generate a first light emission signal EM1 of an off-state and a second light emission signal EM2 of an on state in response to the second mode state of the mode control signal Input_mode1 to supply the generated first and second light emission signals EM1 and EM2 to the pixel circuits. For example, the first light emission signal EM1 can be applied in an off state during the first active period 1201 at which the mode control signal input_mode1 is applied in the second mode state, and the second light emission signal EM2 can be applied in an on state. For example, the first light emission signal EM1 can be applied in an off state during the first active period 1201. The second light emission signal EM2 can be applied in an on state during most of the first active period 1201, and can be applied in an off state only during a partial period synchronized with the common light emission signal EM0.

In the embodiment, the gate driver can generate a first light emission signal EM1 of an on state and a second light emission signal EM2 of an off-state in response to the first mode state of the mode control signal Input_mode1 to supply the first light emission signal EM1 and the off-state second light emission signal EM2 to the pixel circuits. For example, the first light emission signal EM1 can be applied in an on state during the second active period 1202 at which the mode control signal input_mode1 is applied in the first mode state, and the second light emission signal EM2 can be applied in an off state. For example, the second light emission signal EM2 can be applied in an off state during the second active period 1202, and the first light emission signal EM1 can be applied in an on state during most of the second active period 1202 and can be applied in an off state only during a partial period synchronized with the common light emission signal EM0.

FIGS. 13 to 15 are views illustrating an example of a screen displayed in accordance with a mode in a display apparatus according to the embodiment of the present disclosure.

FIG. 13 illustrates a display apparatus viewed from a driver's seat in response to the operation of the display apparatus in the second mode. In the embodiment, when the display apparatus operates in the second mode, the first area in which a first pixel circuit (e.g., the first pixel circuit 1101 of FIG. 11) is disposed can have a viewing angle of a first value, and the second area in which a second pixel circuit (e.g., the second pixel circuit 1102 of FIG. 11) is disposed can have a viewing angle of a second value (a predesignated value less than the first value). In this case, as shown, the content displayed in the first area can be recognized in the driver's seat. However, the content displayed in the second area cannot be recognized in the driver's seat due to the limitation of the viewing angle.

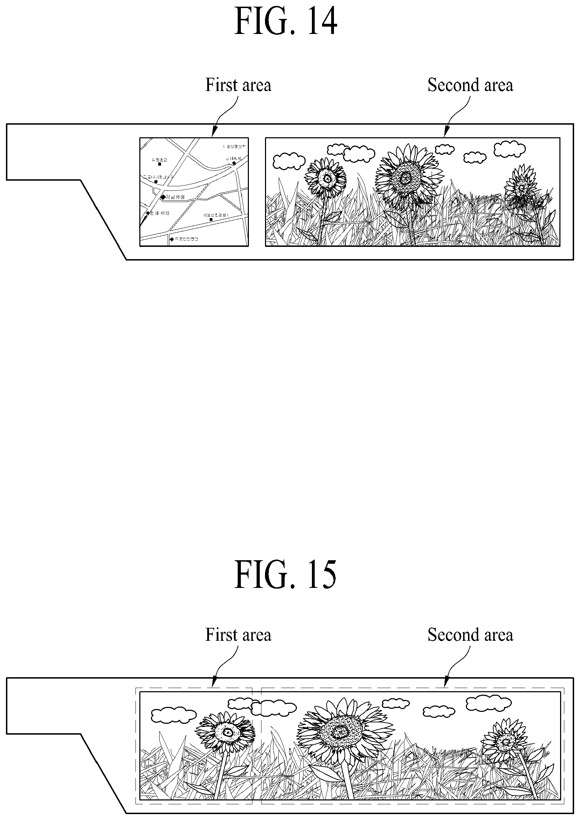

FIG. 14 illustrates a display apparatus viewed from a passenger seat in the same situation as that of FIG. 13. The viewing angle of the first value is a value set to be greater than the second value so that the content can be recognized in a plurality of directions, and the content displayed in the first area can be recognized in the passenger seat (recognized even in the driver's seat). The viewing angle of the second value is a value set to be smaller than the first value so that the content can be recognized with respect to the passenger seat disposed to be adjacent to the second area, and the content displayed in the second area can be recognized in the passenger seat but cannot be recognized in the driver's seat.

In the embodiment, FIG. 14 can represent a display apparatus viewed from a driver's seat and a passenger seat when operating in a first mode. The first mode allows the first area and the second area to be recognized in the vicinity of the display apparatus as well as the driver's seat and the passenger seat. Therefore, as shown in FIG. 14, the contents of the first area and the second area can be recognized in each of the driver's seat and the passenger seat. That is, in the first mode, the same content can be recognized in the driver's seat and the passenger seat.

FIG. 15 illustrates an example of one content that is displayed by being shared by the first area and the second area. In detail, FIG. 15 illustrates an example of one content displayed in a wider area including the first area and the second area in the first mode. Since the same content can be recognized in each of the driver's seat and the passenger seat in the first mode, the content can be recognized in the form shown in FIG. 15 in each of the driver's seat and the passenger seat.

According to the embodiment, the situation of FIG. 15, in which one content is shared and displayed, can be maintained and then required to be switched to the second mode. In this case, a predesignated content can be displayed in the first area, and the shared content can be displayed only in the second area. The content that is predesignated to be displayed in the first area can include, for example, navigation information, weather information or driving information as a content that does not disturb driving. As another example, the predesignated content can include a content corresponding to an empty screen such that no content is displayed, as a black screen.

The display apparatus and the display panel included in the display apparatus according to the embodiment of the present disclosure can be described as follows.

The display apparatus according to the present disclosure can comprise a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor, a second pixel circuit including a second driving transistor, a third transistor receiving the first light emission signal, a fourth transistor receiving the second light emission signal, a third light emitting element connected to the third transistor and a fourth light emitting element connected to the fourth transistor, at least three first lenses disposed on the first light emitting element, the second light emitting element and the third light emitting element, respectively, and at least one second lens disposed on the fourth light emitting element.

According to some embodiment of the present disclosure, a plane of the first lens can correspond to a rectangle extended in one direction, and a plane of the second lens can correspond to a circle. The cross-section of each of the first lens and the second lens can correspond to a semicircular shape. A size of the second lens can be larger than that of a light emitting area of the fourth light emitting element. The first lens can control a moving direction of light to be in a first direction and a second direction, and the second lens can control the moving direction of light to be in the first direction.

According to some embodiment of the present disclosure, the gate driving circuit can provide the first light emission signal in response to driving of a first mode and provide the second light emission signal in response to driving of a second mode. The first pixel circuit can be disposed in a first area operating in the first mode, and the second pixel circuit can be disposed in a second area operating in the first mode or the second mode. A size of the first area can be smaller than that of the second area. When the display apparatus is disposed in a vehicle, the first area can be disposed to be more adjacent to a driver's seat of the vehicle than a passenger seat of the vehicle. When the display apparatus is disposed in a vehicle, the second area can be disposed to more adjacent to a passenger seat of the vehicle than a driver's seat of the vehicle.

According to some embodiment of the present disclosure, the first light emitting element, the second light emitting element, the third light emitting element and the fourth light emitting element can emit light of a first color.

According to some embodiment of the present disclosure, the first light emitting element and the second light emitting element can emit light of a first color, and the third light emitting element and the fourth light emitting element can emit light of a second color.

According to some embodiment of the present disclosure, each of the first pixel circuit and the second pixel circuit further can include a transistor receiving a common light emission signal.

The display panel according to the present disclosure can comprise a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor, a second pixel circuit including a second driving transistor, a third transistor receiving the first light emission signal, a fourth transistor receiving the second light emission signal, a third light emitting element connected to the third transistor and a fourth light emitting element connected to the fourth transistor, at least three first lenses disposed on the first light emitting element, the second light emitting element and the third light emitting element, respectively, and at least one second lens disposed on the fourth light emitting element.

According to some embodiment of the present disclosure, a plane of the first lens can correspond to a rectangle extended in one direction, a plane of the second lens can correspond to a circle, and a cross-section of each of the first lens and the second lens can correspond to a semicircular shape. The first lens can control a moving direction of light to be in a first direction and a second direction, and the second lens can control the moving direction of light to be in the first direction.

According to some embodiment of the present disclosure, the gate driving circuit can provide the first light emission signal in response to driving of a first mode and provide the second light emission signal in response to driving of a second mode.

According to some embodiment of the present disclosure, the first pixel circuit can be disposed in a first area operating in the first mode, and the second pixel circuit can be disposed in a second area operating in the first mode or the second mode.

According to some embodiment of the present disclosure, when the display panel is disposed in a vehicle, the first area can be disposed to be more adjacent to a driver's seat of the vehicle than a passenger seat of the vehicle.

According to some embodiment of the present disclosure, each of the first pixel circuit and the second pixel circuit further can include a transistor receiving a common light emission signal.

According to the present disclosure, the following advantageous effects can be obtained.

In the pixel circuit and the display apparatus according to the present disclosure, the viewing angle of the display apparatus can be adjusted in accordance with the mode based on the plurality of light emitting elements and the lenses disposed on the plurality of light emitting elements. Therefore, the pixel circuit and the display apparatus can provide a content suitable for a user's situation.

It will be apparent to those skilled in the art that the present disclosure described above is not limited by the above-described embodiments and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.
Also disclosed are a number of examples according to the following numbers clauses.
Clause 1. A display apparatus comprising:
   a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor;
   a second pixel circuit including a second driving transistor, a third transistor receiving the first light emission signal, a fourth transistor receiving the second light emission signal, a third light emitting element connected to the third transistor and a fourth light emitting element connected to the fourth transistor;
   at least three first lenses disposed on the first light emitting element, the second light emitting element and the third light emitting element, respectively; and
   at least one second lens disposed on the fourth light emitting element.
Clause 2. The display apparatus of clause 1, wherein a plane of the first lens corresponds to a rectangle extended in one direction, and a plane of the second lens corresponds to a circle.
Clause 3. The display apparatus of any preceding clause, wherein a cross-section of each of the first lens and the second lens corresponds to a semicircular shape.
Clause 4. The display apparatus of any preceding clause, wherein a size of the second lens is larger than that of a light emitting area of the fourth light emitting element.
Clause 5. The display apparatus of any preceding clause, wherein the first lens controls a moving direction of light to be in a first direction and a second direction, and
   the second lens controls the moving direction of light to be in the first direction.
Clause 6. The display apparatus of any preceding clause, wherein the gate driving circuit provides the first light emission signal in response to driving of a first mode and provides the second light emission signal in response to driving of a second mode.
Clause 7. The display apparatus of clause 6, wherein the first pixel circuit is disposed in a first area operating in the first mode, and
   the second pixel circuit is disposed in a second area operating in the first mode or the second mode.
Clause 8. The display apparatus of clause 7, wherein a size of the first area is smaller than that of the second area.
Clause 9. The display apparatus of clause 8, wherein, when the display apparatus is disposed in a vehicle, the first area is disposed to be more adjacent to a driver's seat of the vehicle than a passenger seat of the vehicle.
Clause 10.The display apparatus of clause 8, wherein, when the display apparatus is disposed in a vehicle, the second area is disposed to more adjacent to a passenger seat of the vehicle than a driver's seat of the vehicle.
Clause 11 The display apparatus of any preceding clause, wherein the first light emitting element, the second light emitting element, the third light emitting element and the fourth light emitting element emit light of a first color.
Clause 12.The display apparatus of any preceding clause, wherein the first light emitting element and the second light emitting element emit light of a first color, and
   the third light emitting element and the fourth light emitting element emit light of a second color.
Clause 13.The display apparatus of any preceding clause, wherein each of the first pixel circuit and the second pixel circuit further includes a transistor receiving a common light emission signal.
Clause 14.A display panel comprising:
   a first pixel circuit including a first driving transistor, a first transistor receiving a first light emission signal from a gate driving circuit, a second transistor receiving a second light emission signal from the gate driving circuit, a first light emitting element connected to the first transistor and a second light emitting element connected to the second transistor;
   a second pixel circuit including a second driving transistor, a third transistor receiving the first light emission signal, a fourth transistor receiving the second light emission signal, a third light emitting element connected to the third transistor and a fourth light emitting element connected to the fourth transistor;
   at least three first lenses disposed on the first light emitting element, the second light emitting element and the third light emitting element, respectively; and
   at least one second lens disposed on the fourth light emitting element.
Clause 15.The display panel of clause 14, wherein a plane of the first lens corresponds to a rectangle extended in one direction, a plane of the second lens corresponds to a circle, and a cross-section of each of the first lens and the second lens corresponds to a semicircular shape.
Clause 16.The display panel of clause 14 or clause 15, wherein the first lens controls a moving direction of light to be in a first direction and a second direction, and
   the second lens controls the moving direction of light to be in the first direction.
Clause 17.The display panel according to any of clauses 14 to 16, wherein the gate driving circuit provides the first light emission signal in response to driving of a first mode and provides the second light emission signal in response to driving of a second mode.
Clause 18.The display panel of clause 17, wherein the first pixel circuit is disposed in a first area operating in the first mode, and
   the second pixel circuit is disposed in a second area operating in the first mode or the second mode.
Clause 19.The display panel according to any of clauses 14 to 18, wherein, when the display panel is disposed in a vehicle, the first area is disposed to be more adjacent to a driver's seat of the vehicle than a passenger seat of the vehicle.
Clause 20.The display panel according to any of clauses 14 to 19, wherein each of the first pixel circuit and the second pixel circuit further includes a transistor receiving a common light emission signal.

## Claims

1. A display apparatus comprising:
a first pixel circuit (1101) corresponding to a first area (710, 810) of the display apparatus, the first pixel circuit including:
a first driving transistor (DT1), a first transistor (T1) receiving a first light emission signal from a gate driving circuit (730, 830), a second transistor (T2) receiving a second light emission signal from the gate driving circuit, a first light emitting element (ED1) connected to the first transistor, and a second light emitting element (ED2) connected to the second transistor;
a second pixel circuit (1102) corresponding to a second area (720, 820) of the display apparatus, the second pixel circuit including:
a second driving transistor (DT2), a third transistor (T3) receiving the first light emission signal, a fourth transistor (T4) receiving the second light emission signal, a third light emitting element (ED3) connected to the third transistor, and a fourth light emitting element (ED4) connected to the fourth transistor;
at least three first lenses (510) disposed on the first light emitting element, the second light emitting element and the third light emitting element, respectively; and
at least one second lens (520) disposed on the fourth light emitting element.

2. The display apparatus of claim 1, wherein at least one of the at least three first lenses has a rectangular shape extended in one direction in the plane of the display device, and at least one of the at least one second lenses has a circular shape in the plane of the display device.

3. The display apparatus of claim 1 or claim 2, wherein a cross-section of each of the first lens and the second lens corresponds to a semicircular shape.

4. The display apparatus of any preceding claim, wherein a size of the second lens is larger than that of a light emitting area of the fourth light emitting element.

5. The display apparatus of any preceding claim, wherein the first lens is configured to control a moving direction of light to be in a first direction and a second direction, and
the second lens is configured to control the moving direction of light to be in the first direction.

6. The display apparatus of any preceding claim, wherein the gate driving circuit is configured to provide the first light emission signal in response to driving of a first mode and is configured to provide the second light emission signal in response to driving of a second mode.

7. The display apparatus of claim 6, wherein the first pixel circuit is disposed in the first area operating in the first mode, and
the second pixel circuit is disposed in the second area operating in the first mode or the second mode.

8. The display apparatus of claim 7, wherein a size of the first area is smaller than that of the second area.

9. A vehicle comprising the display apparatus of claim 8, wherein the display apparatus is disposed in the vehicle, and wherein the first area is disposed to be more adjacent to a driver's seat of the vehicle than a passenger seat of the vehicle.

10. A vehicle comprising the display apparatus of claim 8, wherein the display apparatus is disposed in the vehicle, and wherein the second area is disposed to more adjacent to a passenger seat of the vehicle than a driver's seat of the vehicle.

11. The display apparatus of any preceding claim, wherein the first light emitting element, the second light emitting element, the third light emitting element and the fourth light emitting element emit light of a first color.

12. The display apparatus according to any of claims 1 to 10, wherein the first light emitting element and the second light emitting element emit light of a first color, and
the third light emitting element and the fourth light emitting element emit light of a second color.

13. The display apparatus of any preceding claim, wherein each of the first pixel circuit and the second pixel circuit further includes a transistor receiving a common light emission signal.

14. The display apparatus according to any preceding claim, wherein the display apparatus comprises a display panel.
